(19) Europäisches Patentamt
European Patent Office
Office européen des brevets

(11) Publication number: **0 150 421 B1**

(12) **EUROPEAN PATENT SPECIFICATION**

(45) Date of publication of patent specification: **02.08.89**

(51) Int. Cl.[4]: **H 03 K 17/96,** G 06 K 11/06

(21) Application number: **84115648.2**

(22) Date of filing: **17.12.84**

(54) **Capacitance-variation-sensitive touch sensing array system.**

(30) Priority: **27.12.83 US 566045**

(43) Date of publication of application:
**07.08.85 Bulletin 85/32**

(45) Publication of the grant of the patent:
**02.08.89 Bulletin 89/31**

(84) Designated Contracting States:
**AT BE CH DE FR GB IT LI LU NL SE**

(56) References cited:
**US-A-4 145 748**
**US-A-4 186 392**
**US-A-4 233 522**
**US-A-4 281 323**
**US-A-4 290 052**
**US-A-4 305 135**
**PATENT ABSTRACTS OF JAPAN, vol. 7, no. 182, 11th August 1983, page (E-192) (1327) & JP-A-58-85636**

**The file contains technical information submitted after the application was filed and not included in this specification**

(73) Proprietor: **Integrated Touch Arrays, Inc.**
**7327 Cuvier Street**
**La Jolla California 92037 (US)**

(72) Inventor: **Evans, John W.**
**7327 Cuvier Street**
**La Jolla California 92037 (US)**

(74) Representative: **Strohschänk, Heinz, Dipl.-Ing. et al**
**Patentanwälte Strohschänk, Uri & Strasser**
**Innere Wiener Strasse 8**
**D-8000 München 80 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 150 421 B1**

## Description

### BACKGROUND OF THE INVENTION

The present invention pertains to improvements in capacitance-variation-sensitive touch sensing array arrangements.

A touch sensing array arrangement may include an array of individual touch responsive areas which may be operated as keys on a keyboard or may include a single relatively large touch responsive area which may be operated for control purposes as a touch pad to provide an indication associated with a given position in the array. In a capacitance-variation-sensitive touch sensing array arrangement, the touching of a touch responsive area results in a variation of the capacitance between one or more electrodes and circuit ground. This variation results in the variation of a sense signal produced on one or more sense lines coupled to the respective electrodes. In a typical capacitance-variation-sensitive touch sensing array arrangement, each electrode is driven by an alternating current or pulse signal. Sense signals are produced on the respective sense lines coupled to the respective driven electrodes. The sense signals are processed to determine whether a touch responsive area has been touched by an operator.

A typical touch sensing array has three types of conductors: drive lines, sense lines, and electrodes.

A drive line is a conductor coupled to a drive signal generator and capacitively coupled to one or more electrodes. Typically an enlarged portion of the drive line constitutes a plate of a drive line-to-electrode capacitor.

A sense line is a conductor coupled to a sense signal detector and capacitively coupled to one or more electrodes. Typically an enlarged portion of the sense line constitutes a plate of an electrode-to-sense line capacitor.

An electrode is a conductor capacitively coupled to at least one drive line and capacitively coupled to at least one sense line. Typically an electrode has one or more enlarged portions or plates, hereafter called tabs, which furnish a capacitor plate to complete a capacitive coupling between the electrode and the body of an operator, and thereby to circuit ground, when the tab or the area overlying the tab is touched by a finger of the operator. The electrode part of a drive line-to-electrode capacitor or electrode-to-sense line capacitor may be one or more tabs of the electrode, or may be a conductive plate of the electrode not serving as a tab.

In this Specification, an electrode which includes a connected series of conductive tabs is called an antenna line. There is a wide range of possible configurations of the tabs of an antenna line. For example, the tabs may be arranged as a chain along a common connector line or may be arranged as appendages of a common connector line. Typically, the antenna lines are designed to include a connector-line extending into a touch responsive area from the nodes common to both the drive line-to-electrode capacitor and the electrode-to-sense line capacitor.

U. S. Patent Number 4,145,748 to Eichelberger and Butler is most relevant to the present invention. This patent describes a touch sensing array involving drive lines, sense lines, and electrodes. In this arrangement, there is a unique electrode at the intersection of each drive line and sense line, and each electrode is associated with only one key. The number of keys is equal to the product of the number of drive lines and the number of sense lines. Under the direction of control logic means, voltage pulses are applied sequentially to the individual drive lines and the resulting signals on the sense lines are individually processed by an A/D converter to produce a digital output count uniquely associated with a pair made up of a single drive line and a single sense line and therefore with the unique electrode which lies at the intersection of said single drive line and said single sense line. The digital output associated with each electrode is compared to a "no-touch" digital count unique to that electrode which is stored in a memory and updated periodically by a count of at most one. Each comparison of a digital count associated with a specific electrode to the "no-touch" digital count associated with that electrode, results in an independent determination of the presence or absence of touch of that electrode. In the event of an extended dwell time of operator touch, the "no-touch" digital count becomes incorrect as an indicator of the absence of touch for the key(s) touched. This is because the periodic updates occur regularly, even during the dwell period. This condition may result in "false negatives" wherein the touch array is not responsive to operator touch of affected keys. The condition is corrected after a sufficient number of periodic updates in the absence of operator touch.

Other relevant teachings in the prior art are described below.

Several touch sensing array arrangements are described in U. S. Patent Number 4,233,522 to Grummer and Hendriks. Each of these arrangements involves one drive line, a plurality of sense lines and a plurality of electrodes. The sense lines are divided into row sense lines and column sense lines and there are a number of keys equal to the product of the number of row sense lines and the number of column sense lines. Each sense line is connected to a unique detection circuit. A common feature of these arrangements is an array of touch actuated keys. Each key is composed in part of two tabs; each tab is a directly touchable conductive plate. The tabs are arranged on the top side of a substrate in a coordinate grid of rows and columns where each row of tabs is associated with a unique row sense line and each column of tabs is associated with a unique column sense line. Each key has one row tab and one column tab. Actuation of a selected key is brought about by concurrent direct touching of the two tabs of the key. In a first and second embodiment, the tabs of each row and the tabs of each column are electrically connected to form antenna

lines. This requires crossing over of selected conductor runs connecting the tabs. In the first embodiment, on the bottom surface of the substrate, there is a single drive line which delivers a common drive signal to each of the antenna lines; the coupling of the drive line to the antenna lines is capacitive and is effected by a plurality of expanded conductive plates linked to the drive line and underlying a portion of each of the tabs of each antenna line; also on the bottom surface of the substrate are a plurality of sense lines; there is a unique sense line for each row antenna line and for each column antenna line; each sense line is capacitively coupled to a particular row or column antenna line by expanded conductive plates linked to the sense line and underlying the tabs of the antenna line. Crossing over of selected conductor runs is required on the bottom surface of the substrate. In the second embodiment, there are no conductors on the bottom side of the substrate and the capacitive couplings of the drive line and of the sense lines to row and column antenna lines are carried out using discrete components in an electrical circuit located separate from the touch panel. A third embodiment resembles the second embodiment except that there are two layers of conductive traces on the top side of the supporting substrate and crossing over of conductive runs is not required; these two layers of conductive traces are separated by a thin dielectric film; the tabs of the columns lie on the top side of this dielectric film and are connected by conductive traces as in embodiments one and two; the tabs of each row are also on the top side of the dielectric film but are not linked to form a single conductor; each tab in a row overlies an expanded portion of a single conductor on the bottom side of the dielectric film and thereby is strongly capacitively coupled to this single conductor which is coupled to the common drive line and to a unique sense line as in embodiment two. In all three of the embodiments, the detection circuits connected to the sense lines are scanned in a sequential manner to detect touch. Because of the direct touch of the touchable plates, a capacitive coupling to ground on the order of 100 pf is brought about by operator touch. Changes of this large magnitude can be detected by very simple means. Apart from the scanning process, each detection circuit operates independently to report a state of touch or no touch for a particular row or column. The logic of key touch reporting is based on the outputs of the independent detection circuits.

In U. S. Patent Number 4,290,052 to Eichelberger et al., a physical layout of a touch sensing array is given. Touch sensing circuitry is fabricated on a double sided printed circuit board adhesively bonded to the bottom surface of an insulative substrate such as glass. Squarish touch electrodes are formed on the top side of the printed circuit board and transmitter (drive line) and receiver (sense line) electrode tabs in registration therewith are formed on the bottom side of the printed circuit board. Electrical components and interconnection leads are fabricated as an integral part of the conductor patterns on the surfaces of the printed circuit board. The number of keys is equal to the product of the number of drive lines and the number of sense lines.

In another type of touch sensing array arrangement, the drive lines and sense lines are combined to form a plurality of drive/sense lines. A touch sensing array of this type is described in U. S. Patent Number 3,757,322 to Harold Barkan et al. In this device, there is a coordinate grid made up of row and column antenna lines and each antenna line is coupled to a unique drive/sense line; there is a key at the intersection of each row and column antenna line; the number of keys is equal to the product of the number of row antenna lines and the number of column antenna lines. The operator concurrently and directly touches a tab of a row antenna line and a tab of a column antenna line to activate a key.

## SUMMARY OF THE INVENTION

The capacitance-variation-sensitive touch sensing array arrangement of the present invention includes electrodes configured as an array of antenna lines with each antenna line including a connected series of conductive tabs; an array of drive lines with each drive line being capacitively coupled to a plurality of the antenna lines by means of drive line-to-antenna capacitors; a drive signal generator for applying drive signals to the drive lines to drive the antenna lines coupled thereto; an array of sense lines with each of the sense lines being capacitively coupled to respective ones of a plurality of the antenna lines by means of antenna-to-sense line capacitors to derive sense signals from the antenna lines when drive signals are applied to the drive lines; and means coupled to the sense lines for sensing the sense signals on the respective sense lines, with the amplitudes of the respective sense signals being dependent upon whether the capacitance between circuit ground and a driven antenna line coupled to the sense line is increased by an operator touching an area overlying a tab of a driven antenna line; and a signal processing arrangement coupled to the sensing means for processing the sense signals derived from drive signals applied to the capacitively coupled series connected drive lines, antenna lines, and sense lines to provide information associated with touch by an operator. Preferably the sense signals are converted by analog-to-digital conversion to sense signal values for processing by the signal processing arrangement. The present invention includes improvements in the driving and sensing means which allow the operation of a very large touch sensing array.

A preferred embodiment of the present invention is a keyboard having the following advantages:

(i) In common with U. S. Patent Number 4,233,522 cited above, there are electrodes configured as a coordinate grid of row antenna lines and column antenna lines and there is a key at each intersection of a row antenna line and a column antenna line.

(ii) The coordinate grid of antenna lines is covered with a protective dielectric layer; the close proximity

of an operator's finger to tabs from a plurality of the antenna lines rather than direct operator touch of tabs of the antenna lines is detected.

(iii) In common with U. S. Patent Number 4,145,748 cited above, the number of electrodes is equal to the product of the number of drive lines and the number of sense lines because each electrode is associated with a unique pair made up of one drive line and one sense line.

(iv) The combination of features (i) and (iii) makes practical the construction of touch arrays of one or more thousands of keys. The combined features of having the electrodes configured as antenna lines forming a coordinate grid of rows and columns underlying a touch responsive area, of having the number of antenna lines greater than the sum of the number of drive lines and the number of sense lines, and of having the number of keys greater than the number of antenna lines are not present in the prior art.

(v) Novel and improved drive signal generation means for applying drive signals to drive lines allows the amplitude of sense signals to be made low in relation to the variation in the amplitude of the sense signals resulting from touch by an operator.

(vi) A complete scan of the touch array under microprocessor control produces a set of digital sense signal values; novel and improved processing of the entire set enables the accurate recognition of valid operator touch in designated positions within the touch responsive area even in the presence of considerable stray capacitive coupling in the touch array; in the prior art, processing of sense signal values associated with an individual electrode is carried out independently of responses associated with other electrodes.

(vii) The drive lines, antenna lines, and sense lines may be inexpensively fabricated in a monolithic construction on a thin dielectric substrate in such a manner that only a small number of connections are needed between active circuitry used to detect touch and the drive lines and sense lines; the reduction in the number of connections and lower cost of construction are improvements over the prior art.

(viii) Digital sense signals produced in the arrangement may be processed in such a manner as to allow portions of the touch sensing array not in use to be covered with nonconductive materials such as papers or books.

(ix) The touch responsive areas may be legendized by overlays, which may be sheets of computer printout.

Important aspects of the present invention are given in the following description.

The drive signal generator under the control of a microprocessor and associated control logic is adapted for repetitively applying a sequence of drive signals having different predetermined characteristics to the different drive lines to cause differently characterized sense signals to be derived on a sense line coupled to a plurality of different antenna lines.

The drive signal on each drive line is a periodic occurence of an alternating signal packet that occurs either at a time when all other drive lines have no signal packets or preferably at a time when one other drive line has a synchronously occuring alternating signal packet of opposing polarity. Preferably, at any one time, signals on the drive lines consist of alternating signal packets simultaneously applied to a single pair of drive lines, with the paired signal packets being synchronous with each other, of approximately the same value, and of opposing polarities to thereby cause the amplitude of the sense signals derived in response to said synchronous pair of drive signal packets to be low in relation to the variation in the amplitude of the sense signals resulting from a key being touched by an operator. Such pairing of drive signals of opposing polarity is not present in the prior art. This pairing has the added advantage of enabling the number of required sense signals to be reduced by fifty percent.

The touch sensing array of the present invention is amenable to an inexpensive monolithic construction, wherein a first portion of the antenna line array is supported by one side of a thin dielectric substrate and a second portion of the antenna line array is supported by the opposite side of the thin dielectric substrate. In alternative embodiments, the drive lines and sense lines are supported by opposite sides of a second thin dielectric substrate that is separated by a third thin dielectric substrate from the first-mentioned dielectric substrate supporting the antenna lines; or the drive lines and sense lines are supported on the same thin dielectric substrate as the antenna lines. In the latter embodiment, a drive line or sense line on one side of the substrate is coupled to each of a plurality of antenna lines on the opposite side of the substrate by a capacitor formed by a first plate supported by the one side of the substrate and extending from the coupled drive line or sense line and a second oppositely disposed plate supported by the opposite side of the substrate and extending from each coupled antenna line.

The touch sensing array arrangement of the present invention can be configured for use as a keyboard. In a preferred embodiment the antenna lines are arrayed in a coordinate grid of rows and columns and each key of the keyboard overlies an enlarged portion, a tab, of one row antenna line and a tab of one column antenna line; and the number of keys is equal to the product of the number of row antenna lines and the number of column antenna lines. The sense signals derived from the row and column antenna lines are processed to indicate valid touch by providing information as to whichever key is touched by an operator.

The touch sensing array arrangement of the present invention also can be configured so that the coordinate position of finger touch in a single large touch responsive area of a touch pad can be sensed. In such embodiments the antenna line array is dimensioned and disposed so that an operator firmly touching his finger to the interior area of a single touch responsive panel overlying and coextensive with the antenna

line array necessarily varies the capacitance to ground of a plurality of antenna lines; and the signal processing arrangement processes the sense signals to indicate valid touch by providing information as to the coordinate position of touch. The processing arrangement processes the relative magnitudes of variations in the sense signals and performs an interpolation routine using these relative magnitudes to provide an estimate of touch position.

In another aspect of the present invention that is applicable in general to capacitance-variation-sensitive touch sensing array arrangements and not merely to the arrangement of the present invention having arrays of drive lines and sense lines capacitively coupled to arrays of antenna lines, sense values in digital form are provided and the processing arrangement processes complete sets of digital sense values iteratively as a group to ascertain the values of variations in the digital sense values and processes the variation values to determine whether said variations resulted from a touch responsive area being touched by an operator. In the processing, operator touch at a specific location is judged to be present when the variation values match a pattern of variation values characteristically associated with touch at that specific location. Such pattern matching constitutes a more powerful and versatile sense signal processing routine than is found in the prior art and allows the recognition of a valid touch response in capacitance-variation-sensitive touch sensing array arrangements in which, because of stray capacitive coupling, a significant change may occur in sense signal values not directly associated with antenna lines underlying the position of operator touch.

In a further aspect of the present invention that likewise is applicable to capacitance-variation-sensitive touch sensing array arrangements in general, sense signal values in digital form are provided in accordance with the amplitudes of the respective sense signals and the processing arrangement processes the sense signals iteratively to determine whether a touch responsive area has been touched by an operator by comparing the sense signal values with baseline values derived from sense signal values provided when no touch responsive area is touched by an operator; and revises the baseline values in response to sensed variations in the sense signal values which are stable over a predetermined number of complete scans of the touch sensing array occurring in the absence of valid touch by an operator. This feature allows portions of the touch sensing array not in use to be covered with nonconductive materials, such as books or papers, without rendering the array inoperative.

Additional features of the present invention are described in relation to the description of the preferred embodiments.

## BRIEF DESCRIPTION OF THE DRAWINGS

Figure 1 is a block diagram of the arrangement of the present invention.

Figure 2 is a partial schematic circuit diagram showing the interconnection between the touch element array and the capacitors in one preferred embodiment of the arrangement of Figure 1.

Figure 3 is a schematic circuit diagram illustrating the underlying theory of touch detection which has been expanded and elaborated in the present invention.

Figure 4 is a schematic exploded cross-sectional diagram illustrating the construction of a touch element in one preferred embodiment of the touch element array of the arrangement of Figure 1.

Figure 5 is a partial plan view illustrating the pattern of drive line, sense line, and antenna line conductors occuring on the top side and bottom side of a thin dielectric substrate in the monolithic construction of one preferred embodiment of the arrangement of Figure 1.

Figure 6 illustrates the timing and polarity of the different drive signal patterns applied to the drive lines by the drive signal generator in one preferred embodiment of the arrangement of Figure 1.

Figures 7 through 12 are flow charts of the program used by the microprocessor to process sense signal values in one preferred embodiment of the arrangement of Figure 1.

Figure 13 is a partial plan view illustrating the construction and relationship of the antenna array and touch elements in an alternative preferred embodiment of the arrangement of Figure 1.

Figure 14 is a schematic exploded cross-sectional view illustrating the construction of the touch sensing arrangement in the alternative preferred embodiment of Figure 13.

Figures 15A through 15D illustrate the relationship between layered arrays of antenna lines, drive lines, and sense lines in the alternative preferred embodiment of Figures 13 and 14.

Figure 16 is a flow chart of microprocessor programming applicable to the alternative preferred embodiment of Figure 13 that is used in addition to the programming illustrated by Figures 7—12.

Figure 17 illustrates the timing and polarity of the different drive signal patterns applied to the drive lines by the drive signal generator in a further preferred embodiment of the arrangement of Figure 1.

Figures 18 and 19 are flow charts of microprocessor programming applicable to the further preferred embodiment of Figure 17 that is used in lieu of the programming illustrated in Figures 8—12.

## DESCRIPTION OF THE PREFERRED EMBODIMENTS

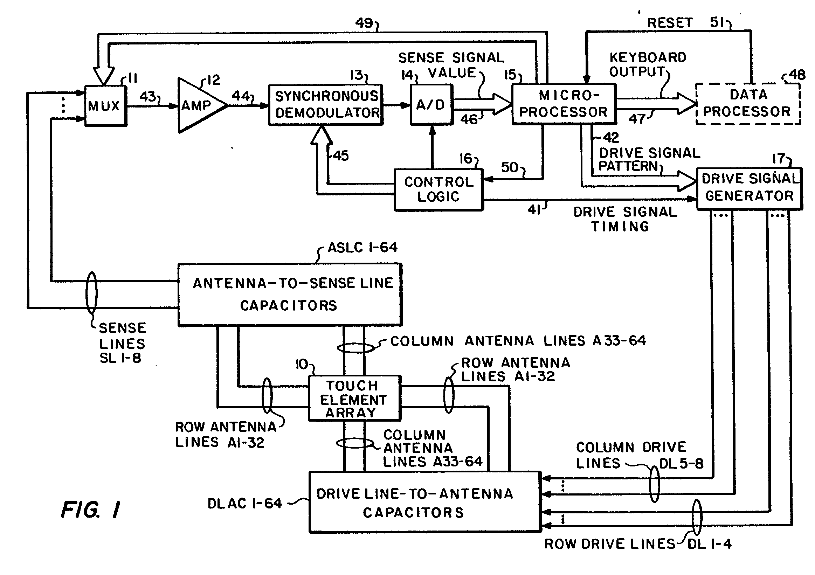

Referring the Figure 1, a preferred embodiment of the capacitance-variation-sensitive touch sensing array arrangement of the present invention includes a 32 × 32 touch element array 10, an antenna line array that includes thirty-two row antenna lines A1—32 and thirty-two column antenna lines A33—64, a drive line array that includes four row drive lines DL1—4 and four column drive lines DL5—8, an array of eight sense lines SL1—8, an array of sixty-four drive line-to-antenna capacitors DLAC1—64, an array of

sixty-four antenna-to-sense line capacitors ASLC1—64, a multiplexer 11, an amplifier circuit 12, a synchronous demodulator 13, an analog-to-digital (A/D) converter 14, a microprocessor 15, a control logic circuit 16 and a drive signal generator 17.

While only thirty-two row antenna lines and thirty-two column antenna lines are included in this embodiment, it is to be understood that with a number "n" of drive lines DL and a number "m" of sense lines SL there may be n × m antenna lines; and if a number "k" of the antenna lines are row antenna lines, then there would be (n × m)-k column antenna lines and k[(n × m)−k] touch elements.

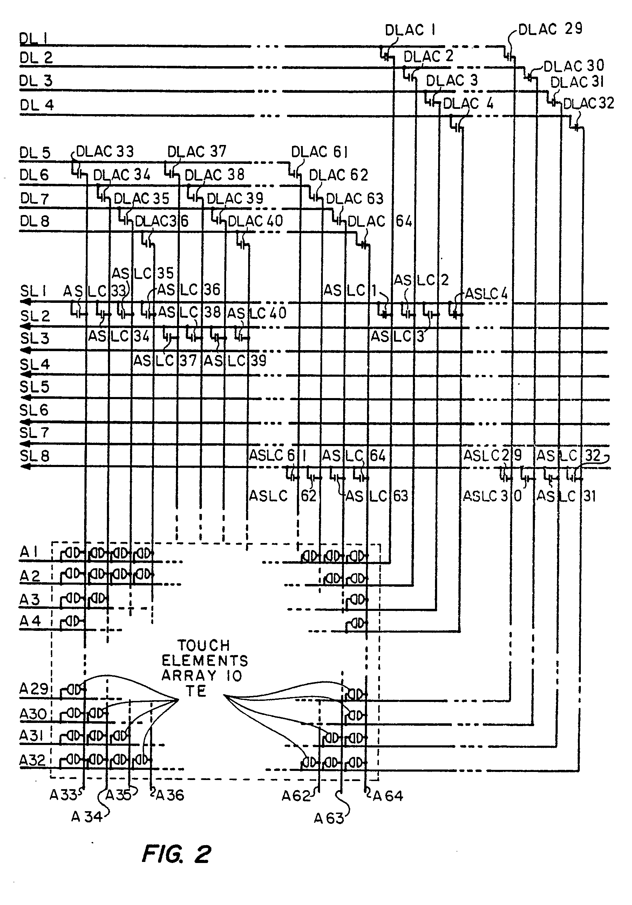

Referring to Figure 2, it is seen that each of the touch elements TE includes two conductive tabs, one tab from a row antenna line and one tab from a column antenna line. Thus, each of the antenna lines A1—64 is associated with thirty-two touch elements TE. The drive lines DL1—8 are capacitively coupled to the antenna lines A1—64 by the drive line-to-antenna capacitors DLAC1—64. The antenna lines A1—64 are capacitively coupled to the sense lines SL1—8 by the antenna-to-sense line capacitors ASLC1—64. Each antenna line A1—64 is capacitively coupled to only one drive line DL and to only one sense line SL. Each of the eight drive lines DL1—8 is capacitively coupled to eight of the sixty-four antenna lines A1—64; and each of the eight sense lines SL1—8 is coupled to eight of the sixty-four antenna lines A1—64. In effect each antenna A1—64 completes a T-bridge connection between a pair made up of a unique one of drive lines DL1—8 and a unique one of sense lines SL1—8.

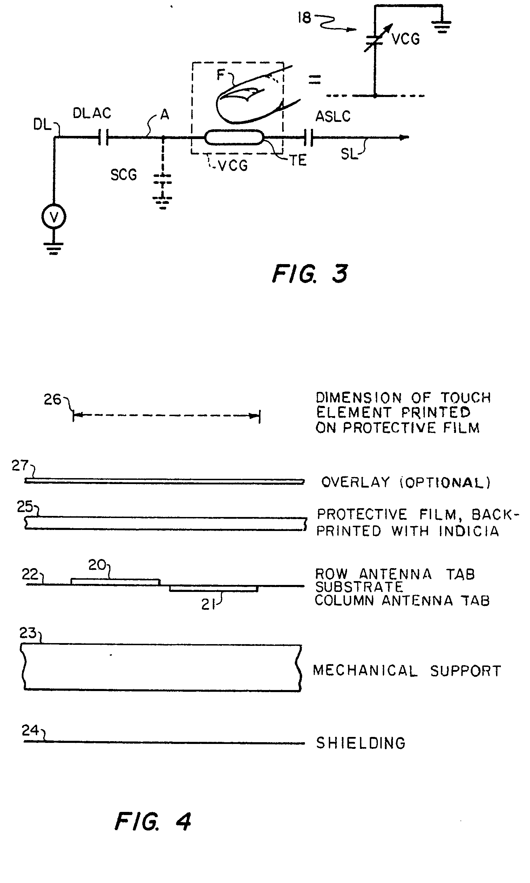

The principle of touch detection is described with reference to Figure 3, wherein a simplified touch element TE is shown in this case as consisting only of a tab of an antenna line A. A drive line DL is capacitively coupled to the antenna line line A by the drive line-to-antenna capacitance DLAC; and the antenna line A is capacitively coupled to a sense line SL by an antenna-to-sense line capacitance ASLC. A drive signal is provided on the drive line DL by a drive signal source V to drive the antenna line A. The touch element TE provides a variable capacitance to ground (VCG) in accordance with the proximity to the touch element TE of an operator's finger F, as shown in the equivalent circuit 18. There also is a stray capacitance from the antenna line A to ground as represented by the capacitor SCG.

When a drive signal (DS) consisting of an applied AC voltage is placed on the drive line DL to drive the antenna line A, a sense signal (SS) is provided on the sense line SL. The amplitude of the sense signal on the sense line SL is dependent upon whether the capacitance between the driven antenna line A and circuit ground is varied by an operator touching the touch element TE. When the operator touches the touch element TE (or even moves his finger F in close proximity to the touch element (TE) the variable capacitance to ground VCG increases to thereby cause the amplitude of the sense signal on the sense line SL to decrease. By providing appropriate means for processing the sense signal provided on the line SL, it is possible to ascertain when the touch element has been affected by an operator. This simplified touch element has been expanded and elaborated in the present invention.

A preferred construction of each touch element in this embodiment is shown in Figure 4. Each touch element TE includes two conductive tabs 20 and 21 that are respectively connected to different antenna lines. One tab 20 is supported on one side of a thin (0.001 inch) dielectric Mylar film substrate 22 and the other tab 21 is supported on the other side of the thin dielectric substrate 22.

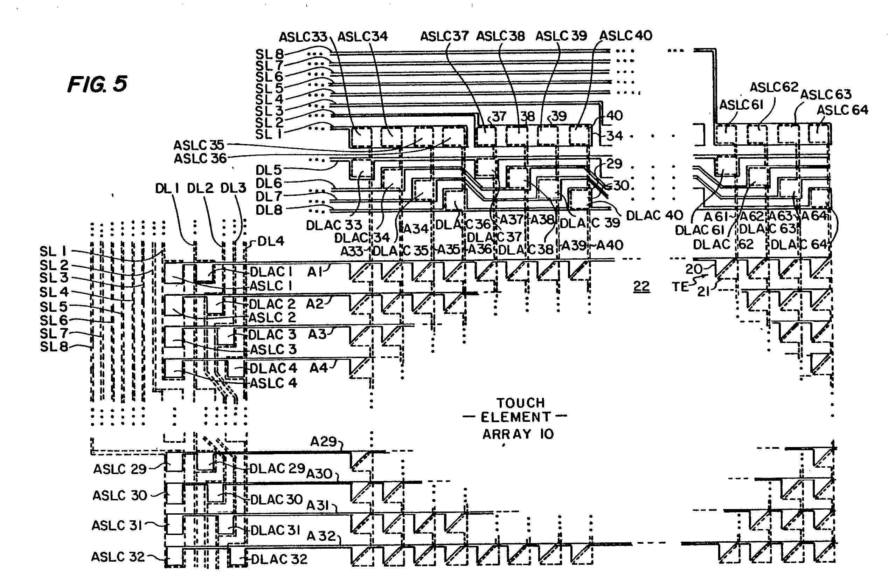

Referring to Figure 5, it is seen that the touch element tabs 20 on the top side of the dielectric substrate 22 (as represented by solid lines) are connected to the row antenna lines A1—32 (represented by solid lines), which likewise are supported on the top side of the substrate 22; and that the touch element tabs 21 on the bottom side of the dielectric substrate 22 (as represented by broken lines) are connected to the column antenna lines A33—64 (represented by broken lines), which likewise are supported on the bottom side of the substrate 22. Each top-side tab 20 extends from a row antenna line; and each corresponding bottom-side tab 21 of the same touch element extends from a column antenna lind adjacent to the position underlying the top-side tab 20 so that the capacitance between both antenna lines connected to the respective tabs 20 and 21 and ground is varied when the touch element is touched by an operator in the proximity of both tabs 20 and 21.

Referring again to Figure 4, the dielectric substrate 22 is supported by a nonconductive mechanical support layer 23, which is covered on its bottom-side by a grounded thin conductive, electrically-sheilding layer 24. The touch element further includes a protective 0.005 inch Lexan plastic film layer 25 covering the unsupported side of the substrate 22 and the tab 20. The protective film layer 25 is backprinted with indicia associated with each of the touch elements in order to identify the touch elements as keys in a keyboard. The dashed line 26 shows the dimension of an outline of the touch element that is backprinted on the protective film 25. Optionally, the touch element may also include a paper overlay layer 27 having different indicia than the backprinted indicia when it is desired to use the touch sensing array in an application in which the backprinted indicia are not appropriate.

Figure 4 illustrates the relative placement of the constituents of the touch element only; and the thicknesses of the layers 22, 23, 24, 25, and 27 are not proportionate. In this preferred embodiment the mechanical supporting layer 23 is 0.25 inch thick. It will be readily appreciated that decreasing the thickness of this supporting layer 23 will increase the proximity of the grounded shielding layer 24 to each of antenna lines A1—64 thereby increasing the stray capacitances to ground SCG of each of A1—64. The entire touch element array 10 is part of a monolithic construction that also includes the drive line-to-antenna capacitors DLAC1—64 and the antenna-to-sense line capacitors ASLC1—64.

The width of each of the respective antenna lines A1—64 is very narrow (0.02 inch) in areas where a

row antenna line A1—32 on one side of the substrate 22 crosses the position of a column antenna line A33—64 on the opposite side of the substrate 22 in order to minimize capacitive coupling between antenna lines on opposite sides of the substrate 22.

Referring again to Figure 5, both the drive lines DL1—8 and the sense lines SL1—8 are supported by the same thin dielectric substrate 22 as supports the antenna lines A1—64. The row drive lines DL1—4 (represented by broken lines) are supported on the bottom side of the substrate 22; and the column drive lines DL5—8 (represented by solid lines) are supported on the top side of the substrate 22.

Drive lines DL1—8 on one side of the substrate 22 are coupled to antenna lines on the opposite side of the substrate 22 by the drive line-to-antenna capacitors DLAC1—64. Each capacitor includes a first plate supported by one side of the substrate 22 and extending from the drive line and a second plate supported by the other side of the substrate 22 and extending from the coupled antenna line and underlying the first plate. For example, consider drive line-to-antenna capacitor DLAC40 which includes a first plate 29 supported on the top side of the substrate 22 and extending from column drive line DL8 on the top side of the substrate 22 and a second plate 30 supported on the bottom side of the substrate 22 and extending from column antenna line A40 on the bottom side of the substrate 22 and underlying the first plate 29.

The sense lines SL1—8 are supported on both sides of the substrate 22, as may be discerned from the representative respective solid and broken lines in Figure 5. The row antenna lines A1—32 on the top side of the substrate 22 are capacitively coupled to the portions of eight sense lines SL1—8 on the bottom side of the substrate 22 respectively by thirty-two of the antenna-to-sense line capacitors, ASLC1—32. Each of the eight sense lines is capacitively coupled to four of the row antenna lines. The column antenna lines A33—64 on the bottom side of the substrate 22 are capacitively coupled to the portions of the eight sense lines SL1—8 on the top side of the substrate 22 respectively by the remaining thirty-two antenna-to-sense line capacitors ASLC33—64. Each such capacitor includes a first plate supported by one side of the substrate 22 and extending from the antenna line and a second plate supported by the other side of the substrate 22 and extending from the coupled sense line, such as shown for capacitors ASLC1—4. This condition is also satisfied by capacitors ASLC37—40 wherein a capacitor plate on one side of the substrate constitutes the first plate for several different capacitors that are defined by separate second plates on the opposite side of the substrate. In capacitors ASLC37—40, a first plate 34 supported on the top side of the substrate 22 and extending from the sense line SL2 supported on the top side of the substrate 22 is in common to each of these capacitors ASLC37—40, and separate second plates 37, 38, 39 and 40 are supported on the bottom side of the substrate 22 and respectively extend from the antenna lines A37, A38, A39 and A40 supported on the bottom side of the substrate 22.

Table 1 shows which drive lines DL and which sense lines SL are respectively coupled to which antenna lines A1—64.

TABLE 1

| | | SL1 | SL2 | SL3 | SL4 | SL5 | SL6 | SL7 | SL8 |
|---|---|---|---|---|---|---|---|---|---|
| ROW | DL1 | 1 | 5 | 9 | 13 | 17 | 21 | 25 | 29 |
| DRIVE | DL2 | 2 | 6 | 10 | 14 | 18 | 22 | 26 | 30 |
| LINES | DL3 | 3 | 7 | 11 | 15 | 19 | 23 | 27 | 31 |
| | DL4 | 4 | 8 | 12 | 16 | 20 | 24 | 28 | 32 |
| COLUMN | DL5 | 33 | 37 | 41 | 45 | 49 | 53 | 57 | 61 |
| DRIVE | DL6 | 34 | 38 | 42 | 46 | 50 | 54 | 58 | 62 |
| LINES | DL7 | 35 | 39 | 43 | 47 | 51 | 55 | 59 | 63 |
| | DL8 | 36 | 40 | 44 | 48 | 52 | 56 | 60 | 64 |

Antenna Line Number

No given drive line and sense line pair is connected to more than one antenna line in common.

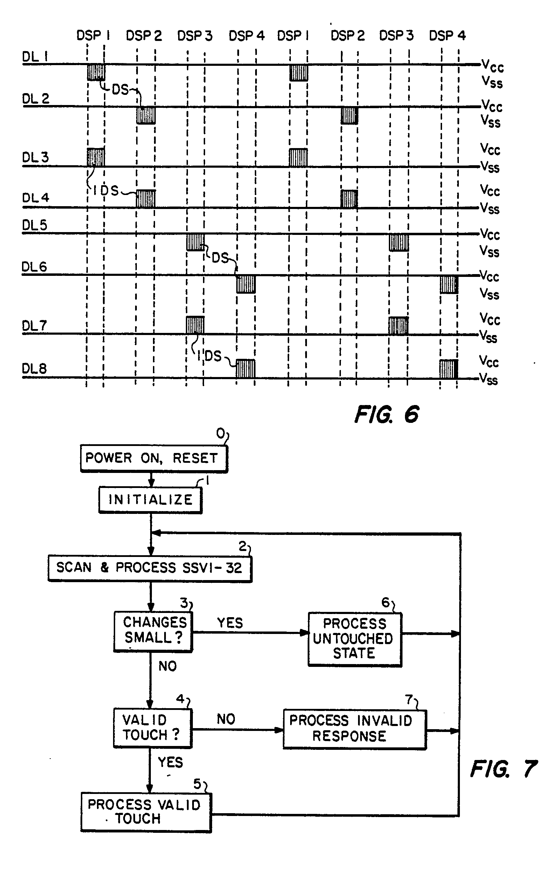

Referring again to Figure 1, drive signals are applied to the drive lines DL1—8 by the drive signal generator 17. The drive signal generator 17 is adapted to respond to drive signal timing information provided on line 41 from the control logic circuit 16 and to drive signal pattern information provided on lines 42 from the microprocessor 15 by repetitively applying a sequence of drive signals having different predetermined characteristics to the different drive lines DL1—8 to cause differently characterized sense signals to be derived on sense lines SL1—8 coupled to a plurality of different antenna lines A1—64. The drive signals are alternating signal packets that differ from each other by being nonsynchronous or by being of opposing polarities if synchronous with each other. Referring to Figure 6, each signal packet contains sixteen cycles of an alternating signal that varies at a predetermined frequency. The different drive signals in combination include nonsynchronous sets of signal packet pairs, with the paired signal packets in each set being synchronous with each other, of approximately the same value, and of opposing

polarities to thereby cause the amplitude of the sense signals derived in response to such synchronous pairs of drive signal packets to be low in relation to the variation in the amplitude of such sense signals resulting from the touch elements being touched by an operator. The signal packets of one polarity are referred to as drive signals DS; and the signal packets of the opposite polarity are referred to as inverted drive signals IDS. In the context of this Specification when no distinction is made between the drive signals DS and the inverted drive signals IDS, the term drive signal refers to whichever type of drive signal pattern (DS or IDS) is applied to the respective drive lines DL1—8.

Referring again to Figure 6, the drive signals are provided on the drive lines DL1—8 by the drive signal generator 17 in a repeating sequence of four different drive signal patterns DSP1, DSP2, DSP3, and DSP4. During DSP1, a drive signal DS is provided on drive line DL1 and an inverted drive signal IDS is provided on drive line DL3.

Table 2 shows the association of the drive signals DS and the inverted drive signals IDS on the respective drive lines DL during the four different drive signal patterns DSP1—4.

TABLE 2

| | DSP1 | DSP2 | DSP3 | DSP4 |
|---|---|---|---|---|
| LINE RECEIVING DS | DL1 | DL2 | DL5 | DL6 |
| LINE RECEIVING IDS | DL3 | DL4 | DL7 | DL8 |

Location of DS and IDS on DL1-8 during DSP1-4

During each drive signal pattern, the paired drive signal DS and inverted drive signal IDS are synchronous with each other, of approximately the same value and of opposing polarities.

The drive signal pattern information on lines 42 indicates the sequence in which the drive signal packets are placed upon given drive lines. Each of the drive lines DL1—8 is dedicated to receiving either drive signals DS or inverted drive signals IDS exclusively, as shown in Figure 6.

Referring again to Figure 1, the multiplexer 11 time-division multiplexes the eight different sense signals on sense lines SL1—8 to provide time-division multiplexed sense signals on line 43 to the amplifier 12. The amplifier 12 is a band pass amplifier centered at the predetermined frequency of the alternating signal within the signal packets of the drive signals. The synchronous demodulator frequency demodulates the signal on line 44 from the amplifier 12. The control logic circuit 16 controls the operation of the synchronous demodulator 13 by a signal on lines 45 to cause the demodulation of a signal packet on line 44 to be synchronous with the generation of the corresponding drive signal packet by the drive signal generator 17. The demodulated signals then are converted from analog signals to digital signals by the A/D converter 14 which provides a respective sense signal value (SSV) on lines 46 for the sense signal derived from one of the sense lines SL1—8 that is selected by the multiplexer 11 during one of drive patterns DSP1—4 (Figure 6). The multiplexing rate is such that a sense signal from only one of the sense lines SL1—8 is provided on line 43 and subsequently demodulated during each occurrence of a drive signal pattern DSP. The sense signal values indicate both the amplitude and the polarity of the sense signals. Because opposing polarity drive signal patterns are provided, the number of sense signal values that must be processed to scan completely the array of touch elements is one-half the number of antenna lines. Thus, for this embodiment, only thirty-two sense signal values need be processed during each complete scan of the touch sensing array.

Table 3 shows a processing sequence identification number for each of the sense signal values (SSV), and the sign under an appropriate convention of the variation in the sense signal value derived from each of the sense lines SL1—8 during each of the respective drive signal patterns DSP1—4 whenever a touch element is touched by an operator with respect to the antenna lines A that are associated with the touch element that is touched by the operator.

TABLE 3

| | ROW | | | | | | COLUMN | | | | | |
|---|---|---|---|---|---|---|---|---|---|---|---|---|
| | DSP1 | | | DSP2 | | | DSP3 | | | DSP4 | | |
| | SSV | SIGN | A | SSV | SIGN | A | SSV | SIGN | A | SSV | SIGN | A |
| SL1 | 1 | + | 1 | 9 | + | 2 | 17 | + | 33 | 25 | + | 34 |
| | | - | 3 | | - | 4 | | - | 35 | | - | 36 |
| SL2 | 2 | + | 5 | 10 | + | 6 | 18 | + | 37 | 26 | + | 38 |
| | | - | 7 | | - | 8 | | - | 39 | | - | 40 |
| SL3 | 3 | + | 9 | 11 | + | 10 | 19 | + | 41 | 27 | + | 42 |
| | | - | 11 | | - | 12 | | - | 43 | | - | 44 |
| SL4 | 4 | + | 13 | 12 | + | 14 | 20 | + | 45 | 28 | + | 46 |
| | | - | 15 | | - | 16 | | - | 47 | | - | 48 |
| SL5 | 5 | + | 17 | 13 | + | 18 | 21 | + | 49 | 29 | + | 50 |
| | | - | 19 | | - | 20 | | - | 51 | | - | 52 |
| SL6 | 6 | + | 21 | 14 | + | 22 | 22 | + | 53 | 30 | + | 54 |
| | | - | 23 | | - | 24 | | - | 55 | | - | 56 |
| SL7 | 7 | + | 25 | 15 | + | 26 | 23 | + | 57 | 31 | + | 58 |
| | | - | 27 | | - | 28 | | - | 59 | | - | 60 |
| SL8 | 8 | + | 29 | 16 | + | 30 | 24 | + | 61 | 32 | + | 62 |
| | | - | 31 | | - | 32 | | - | 63 | | - | 64 |

For example, if the touch element associated with row antenna line A1 and column antenna line A48 is touched by an operator, a positive variation in the sense signal value is derived from sense line SL1 during DSP1 and a negative variation in the sense signal value is derived from sense line SL4 during DSP4.

The microprocessor 15 processes the sense signal values on lines 46 to provide information on lines 47 associated with any particular touch element that is touched by an operator. In this embodiment the touch element array 10 is used as a keyboard for a data processor 48. Accordingly, the information provided by the microprocessor on lines 47 constitutes a keyboard output signal to the data processor 48.

The operation of the multiplexer 11 is controlled by signals provided on lines 49 by the microprocessor 15. The microprocessor also produces an initialization signal on line 50 to the control logic circuit 16, which coordinates the operation of the synchronous demodulator 13, the A/D converter 14, and the drive signal generator 17. The operation of the microprocessor 15 is reset by the data processor 48 by a signal on line 51.

The microprocessor 15 is programmed to process the sense signal values (SSV) on lines 46 iteratively to ascertain the signs and values of the variations (SSVV) in the sense signal values (SSV) and to process the sense signal variation values (SSVV) to determine whether the pattern of variations is that of a single touch element being touched by an operator. The flow charts for this program are shown in Figures 7 through 12.

The sense signal values are processed iteratively by comparing the sense signal values with baseline values derived from sense signal values provided when the touch element array is untouched by an operator to determine which one of three states is present. The first of the three states is an UNTOUCHED state. The second of the three states is a VALID TOUCH state in which a valid touch by an operator is present. The third of the three states is an INVALID RESPONSE state which occurs when neither the first state or the second state is present.

Referring to Figure 7, step 0 represents a power on, reset operation; and in step 1, the variable values are initialized. In step 2, a scan of the touch element array 10 is carried out iteratively with the production of sense signal values SSV1—32 as program input. Initial processing is carried out. In step 3, a test is performed to determine if the sense signal variation values SSVV1—32 are all small. If so, the program branches to step 6 where the UNTOUCHED state is processed. If any of sense signal variation values SSVV1—32 is found not to be small in step 3, the program branches to step 4 where a test is performed to identify the presence or absence of the VALID TOUCH state. The VALID TOUCH state is processed in step 5. In the absence of the VALID TOUCH state the program branches from step 4 to step 7 where an INVALID RESPONSE is processed. Following each of steps 5, 6, or 7 there is a return to step 2.

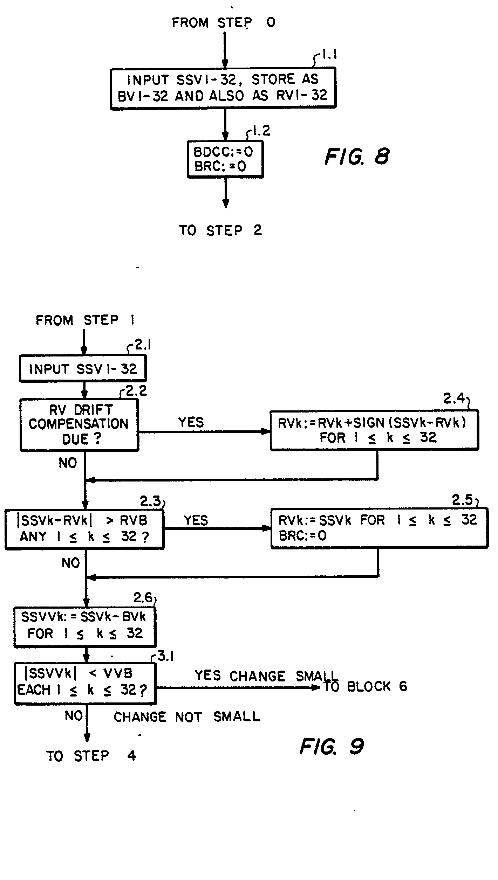

Expansions of steps 1 through 7 of Figure 7 are shown in Figures 8 through 12, with a step-numbering system which agrees in the first digit with that of Figure 7.

Referring to Figure 8, the initialization is shown in steps 1.1 and 1.2 to consist of inputting the sense signal values SSV1—32 and storing these values as baseline values BV1—32 and also as reserve values RV1—32. Next, a baseline drift compensation count (BDCC) and a baseline revision count (BRC) are each initialized to 0. In step 1.2 and in later steps, the "assign" symbol := is used in the usual way to indicate that the value to the right of said symbol is assigned to the variable to the left of said symbol. It is intended in operation that baseline values BV1—32 represent the sense signal values SVV1—32 that would be obtained in the absence of operator touch and thus that the touch element array 10 should be untouched during initialization.

Referring to Figure 9, the microprocessor 15 is programmed to process the sense signal values (SSV) iteratively to determine whether any of the touch elements has been touched by an operator by comparing the sense signal values (SSV) with baseline values (BV) derived from sense signal values (SSV) provided when the touch elements are untouched by an operator to determine whether a sense signal variation value (SSVV) derived from such comparison exceeds a predetermined variation value bound (VVB); and to revise the baseline values (BV) in response to sensed variations in the sense signal values (SSV) over a predetermined number of iterations occurring in the absence of valid touch by an operator. The baseline values are revised in response to sensed variations in the sense signal values which are stable over a predetermined number of iterations and which indicate the INVALID RESPONSE state of the touch element array 10.

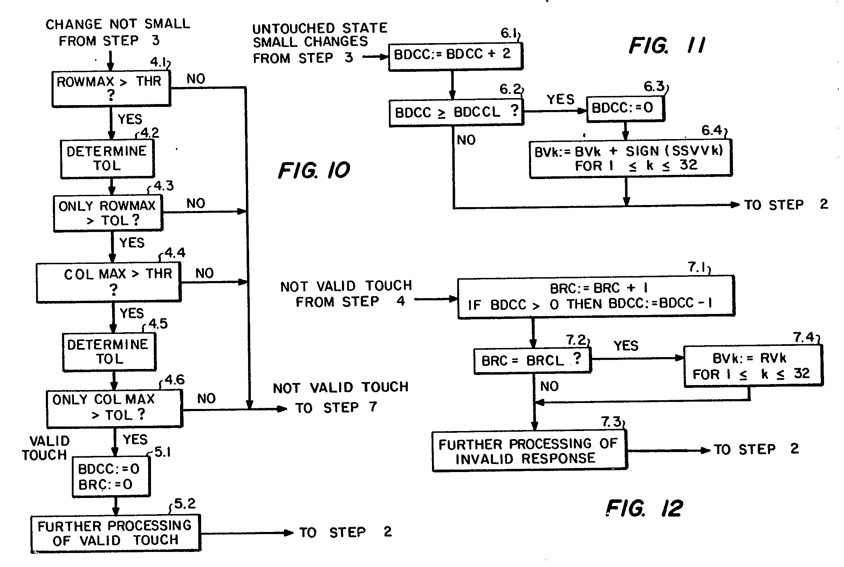

In the course of revising the baseline values (BV), the microprocessor 15 (a) stores a set of reserve values (RV) derived from a set including each of the respective sense signal values (SSV); (b) iteratively compares each sense signal value (SSV) to each corresponding reserve value (RV); (c) revises the stored set of reserve values (RV) to correspond to a current set of sense signal values SSV1—32 whenever the difference between any sense signal value (SSV) and the corresponding reserve value (RV) exceeds a predetermined reserve value bound (RVB); (d) processes the sense signal variation values (SSVV) derived from a current set of sense signal values SSV1—32 whenever any variation value (SSVV) derived from such set exceeds a variation value bound (VVB) to determine whether VVB was exceeded as a result of a touch element being touched by an operator; (e) increments a baseline revision count (BRC) in response to each current set of sense signal values SSV1—32 for which it is determined that the exceeding of the variation value bound VVB was not the result of a touch element being touched by an operator; (f) resets the baseline revision count (BRC) to zero each time the stored set of reserve values (RV) is revised; and (g) revises the baseline values (BV) to correspond to the reserve values (RV) when the baseline revision count (BRC) equals a predetermined revision count limit (BRCL). Step (d) is shown in the flow chart of Figure 10 and steps (e) and (g) are shown in the flow chart of Figure 12. Accordingly, it is seen that the baseline values are revised to correspond to the reserve values when the INVALID RESPONSE state is present for a predetermined number of iterations during which time no revision of the reserve values occurs, no revision of baseline values to correspond to reserve values occurs, and the VALID TOUCH state is not present. It is also seen that the baseline values are updated by either incrementing or decrementing each of the respective baseline values in accordance with whether the baseline value is less or greater than the respective last-provided sense signal value when the UNTOUCHED state is present for a predetermined number of consecutive iterations during which time no updating of the baseline values occurs.

Sense signal values SSV1—32 are input in step 2.1. Next, in step 2.2 a test is done on the baseline revision count BRC. At certain preselected and fixed values of BRC there is a branch to step 2.4 where each of the reserve values RV1—32 is altered as shown so as to become closer by 1 if possible to the respective value of SSV1—32. The SIGN function is employed in this step and in later steps in the usual way where the SIGN of a positive number is plus 1, the SIGN of 0 is 0, and the SIGN of a negative number is minus 1. This operation of step 2.4 is called reserve value drift compensation. Part of the significance of this step 2.4 operation is shown by the test in step 2.3 where if any of the reserve values RV1—32 is found to depart by more than the reserve value bound RVB from the corresponding one of SSV1—32 there is a branch to step 2.5 where all of RV1—32 are given the respective values of the current SSV1—32 and where the baseline revision count (BRC) is reset to 0. In step 2.6 the sense signal variation values SSVV1—32 are calculated as the respective differences of SSV1—32 and BV1—32. In step 3.1, if the magnitude of each of SSVV1—32 is found to be smaller than the variation value bound VVB, the touch element array 10 is judged to be in the UNTOUCHED state and there is a branch to step 6. Otherwise there is a branch to step 4.

Referring next to Figure 10, in the course of processing the sense signal variation values (SSVV) the microprocessor 15 (a) determines whether the maximum variation value (ROWMAX) derived from the row antenna lines A1—32 exceeds a predetermined threshold value (THR); (b) determines whether none of the other variation values (SSVV) derived from the row antenna lines A1—32 exceeds a tolerance value (TOL) that is a predetermined fraction of the maximum variation value (ROWMAX) derived from the row antenna lines A1—32; (c) determines whether the maximum variation value (COLMAX) derived from the column antenna lines A33—64 exceeds the predetermined threshold value (THR); and (d) determines whether none of the other variation values (SSVV) derived from the column antenna lines A33—64 exceeds a tolerance value (TOL) that is a predetermined fraction of the maximum variation value (COLMAX) derived from the column antenna lines A33—64. All of the four immediately preceding recited determinations (a), (b), (c) and

(d) being affirmative indicates that the maximum variation value (ROWMAX) derived from the row antenna lines and the maximum variation value (COLMAX) derived from the column antenna lines each resulted from only a single one of the touch elements being touched instantaneously by an operator.

Tests for a valid touch response are carried out in steps 4.1 through 4.6. The variable ROWMAX is always assigned the value of the largest magnitude of the current set of sense signal variation values SSVV1—16 derived from the row antenna lines A1—32. In step 4.1 ROWMAX is compared to the predetermined threshold value THR. If ROWMAX exceeds THR there is a branch to step 4.2 where the tolerance value TOL is set to some fixed fraction of the value of ROWMAX. Next, in step 4.3 each of the magnitudes of SSVV1—16 other than the one chosen as ROWMAX is compared to TOL. If none of these values exceeds TOL then VALID ROW TOUCH response is judged to be present and the program branches to step 4.4 where the largest magnitude (COLMAX) of the current set of sense signal variation values SSVV17—32 derived from the column antenna lines A33—64 is determined. COLMAX is compared to the threshold value THR. If COLMAX exceeds THR, then TOL is recalculated as a fixed fraction of COLMAX in step 4.5; and in step 4.6, each of the magnitudes of SSVV17—32 other than the one chosen as COLMAX is compared to TOL. If none of these values exceeds TOL, the tests for a VALID TOUCH have been passed and there is an exit to steps 5.1 and 5.2 where a VALID TOUCH is processed. Failing any of the tests of steps 4.1, 4.3, 4.4, or 4.6 causes a branch to step 7 where an INVALID RESPONSE is processed. In step 5.1 which begins the processing of a valid touch, the counts BDCC and BRC are each reset to 0. The significance of these resets will be appreciated when the program flow charts shown in Figures 11 and 12 are describe. In step 5.2 further processing of a VALID TOUCH response is carried out including the appropriate encoding of the touched touch element by row number and by column number which numbers may be calculated using the information in Table 3.

Referring to Figure 11, the microprocessor 15 is further programmed to compensate for drift in the sense signal values (SSV) that are provided when the touch elements are in the untouched state. To effect such compensation, the microprocessor 15 (a) increments the baseline drift compensation count (BDCC) in response to each current set of sense signal values SSV1—32 for which there is no sense signal variation value (SSVV) that exceeds the variation value bound (VVB); (b) revises the baseline value (BV) when the baseline drift compensation count (BDCC) equals a predetermined compensation count limit (BDCCL) by either incrementing or decrementing each of the respective baseline values (BV) in accordance with whether the baseline value is less or greater than the respective last-provided sense signal value (SSV); and (c) resets the baseline drift compensation count (BDCC) to zero upon the baseline values (BV) being revised.

The processing of the UNTOUCHED state is shown in steps 6.1 through 6.4. In step 6.1 the baseline drift compensation count BDCC is incremented by two counts. Next, in step 6.2, BDCC is compared to the predetermined compensation count limit BDCCL. If BDCC has reached or exceeded BDCCL, there is a branch to step 6.3 where BDCC is reset to 0. Next, in step 6.4 each of the baseline values BV1—32 is altered as shown so as to become closer by 1 if possible to the respective value of the current sense signal values SSV1—32.

Referring to Figure 12, the process of compensating for baseline value drift further includes decrementing the baseline drift compensation count (BDCC) to not less than zero in response to each current set of sense signal values SSV1—32 for which a sense signal variation value (SSVV) exceeds the predetermined variation value bound (VVB) except when it is determined that the exceeding of VVB was the result of a touch element being touched by an operator. When the INVALID RESPONSE state occurs only intermittently, the updating of the baseline values is delayed by degree. In step 7.1 the baseline revision count (BRC) is incremented. Next, the baseline drift compensation count BDCC is decremented if BDCC is greater than 0. Next, in step 7.2 BRC is compared to the predetermined revision count limit (BRCL). If there is equality there is a branch to step 7.4 where the baseline values BV1—32 are assigned the respective reserve values RV1—32, as discussed above in relation to the description of the program flow chart shown in Figure 9. Further processing of the INVALID RESPONSE state is carried out in step 7.3 as needed.

Referring again to the program flow chart of Figure 7, it is seen that baseline value drift compensation occurs in step 6, where the UNTOUCHED state is processed, when BDCC reaches BDCCL. BDCC is reset to 0 in step 5, incremented by 2 in step 6, and is decremented by 1 if positive in step 7. Since there is passage through only one of steps 5, 6, or 7 during each iteration (which corresponds to a sequence in which each of drive signal patterns DSP1—4 is repeated for each of the sense lines SL1—8), the condition which brings about baseline value drift compensation is apparent. Also it is seen that complete baseline revision with the resulting replacement of BV1—32 by RV1—32 occurs in step 7, where the INVALID RESPONSE state is processed, when BRC reaches BRCL. BRC is incremented in step 7, is reset to 0 in step 5, and is possibly reset to 0 in step 2. Thus the conditions needed for complete baseline value revision are apparent: first, sufficient stability of SSV1—32 so that the resetting of BRC is avoided in step 2, and second, passage through step 7 BRCL times before passing through step 5.

Further processing of VALID TOUCH or INVALID RESPONSE beyond that indicated in the flow charts of Figures 7—12 may proceed according to well-established techniques in keyboard scanner design.

All numbers are stored in the microprocessor 15 as 8 bit binary numbers and are interpreted in the usual way as signed binary numbers lying between decimal minus 128 and decimal 127. Carry and

overflow bits are ignored in additions and subtractions. As an example, the result of subtracting decimal 127 from decimal minus 128 is plus 1. It is assumed that, in normal use, changes in each of SSV1—32 will not exceed decimal 127 in magnitude and thus that the sign of such changes will be given a correct interpretation in the microprocessor program.

As an example of program parameter choices, suppose that sense signal variation values SSVV of over 16 units are reliably produced by operator touch under typical operating conditions. THR may be set equal to 8. RVB and VVB may be set equal to 4. BDCCL may be chosen so that baseline value drift compensation occurs at the rate of 1 per second when all the SSVs are consistently less than or equal to VVB in magnitude. In the process of Figure 10 in step 4.2 TOL may be assigned the value of ROWMAX/4 and in step 4.5 TOL may be assigned the value of COLMAX/4. BRCL may be chosen so that a complete baseline value revision occurs after 2 seconds of stabilized SSVs in the INVALID RESPONSE state. The preselected values of BRC which lead to a branch to reserve value drift compensation from step 2.2 in the process of Figure 9 may be chosen as 1, 2, 4, 8, . . . up to BRLC.

In an alternative preferred embodiment, the touch element array 10 is adapted so that instead of the touch elements respectively serving as keys of a keyboard, the touch elements are dimensioned and disposed so that an operator firmly touching an interior touch element of the array with his finger necessarily touches a plurality of touch elements simultaneously. In this alternative embodiment the microprocessor 15 is programmed to respond to the sense signal values produced upon a plurality of the touch elements being touched simultaneously so as to provide an output indication of the coordinate position on the touch element array 10 that is touched by the operator. The indication of the position of finger touch may be used in a variety of control situations, such as, for example, selecting the cursor position on a cathode ray tube constituting the display portion of a computer terminal. In other applications, transparent conductive material may be used for the antenna lines and the touch elements and the touch element array may overlay the cathode tube.

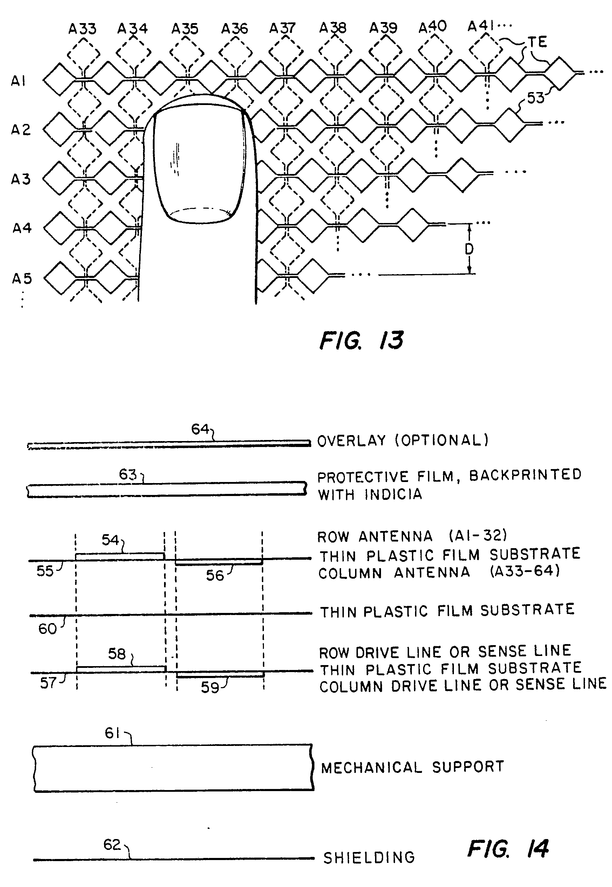

The touch element array of this alternative embodiment is shown in Figure 13, where it is seen that each touch element TE includes only a single tab of one of the antenna lines A1—A64. All of the row antenna lines A1, . . . are supported on one side of a thin dielectric substrate, and all of the column antenna lines A33, . . . are supported on the opposite side of said substrate. Each touch element TE includes only one conductive tab 53. The center line-to-center line distance D between the row antenna lines A1, . . . is 0.25 inch. The column antenna lines A33, . . . are separated by the same distance. The tabs of the antenna lines are square in shape and extend from their respective antenna lines which traverse the touch elements diagonally. Each square has a diagonal dimension of 0.2 inch. The tabs on one side of the substrate do not underlie the tabs on the opposite side of the substrate. Instead, as shown in Figure 13, the tabs on one side of the substrate are disposed symmetrically between the positions of the tabs on the opposite side of the substrate.

The touch element array of this alternative embodiment has the same basic monolithic construction as described above for the touch elements shown in Figure 4, except that the tabs 20 and 21 on opposite sides of the substrate 22 belong to separate touch elements in the embodiment of Figure 13. Also the protective film 25 ordinarily would not be backprinted with indicia to show the outline of each touch element. The use of the optional overlay 27 would be appropriate with this embodiment when it is desired to specify portions of the array as having particular significance. As in the first described preferred embodiment the entire touch array 10 in this alternative preferred embodiment is a part of a monolithic construction that also includes the drive line-to-antenna capacitors DLAC1—64 and the antenna-to-sense line capacitors ASLC1—64 as described above with reference to Figure 5.

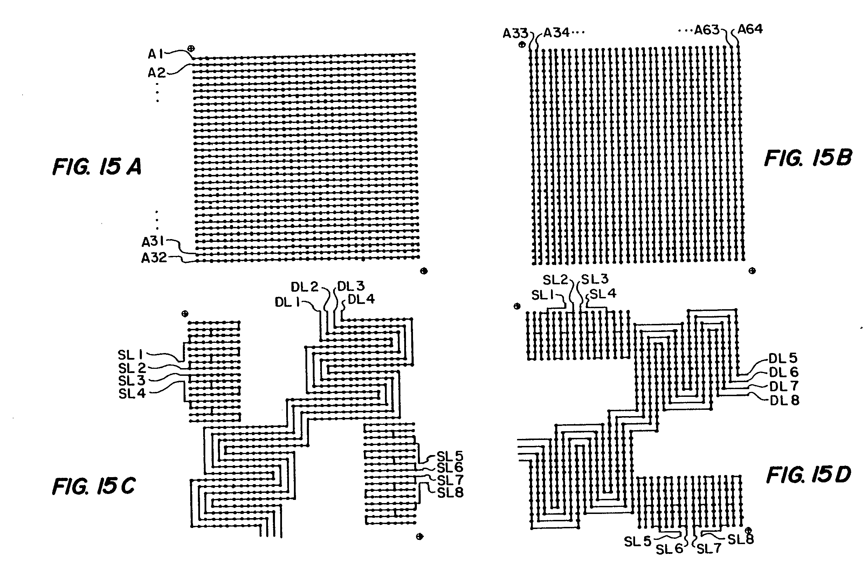

An alternative monolithic construction of the touch element array of Figure 13 in combination with the drive line-to-antenna capacitors DLAC1—64 and the antenna-to-sense line capacitors ASLC1-64 is shown in Figures 14 and 15. Referring to Figure 14, a row antenna line 54 of the array of row antenna lines A1—32 is supported by the top side of a first thin dielectric Mylar film substrate 55; and a column antenna line 56 of the array of column antenna lines A33—64 is supported by the bottom side of the first substrate 55. The drive lines and sense lines are supported by opposite sides of a second thin dielectric Mylar film substrate 57. In the representative cross-sectional view of Figure 14, a line 58 of either the array of row drive lines DL1—4 or the array of sense lines SL1—8 is supported by the top side of the second substrate 57; and a line 59 of either the array of column drive lines DL5—8 or the array of sense lines SL1—8 is supported by the bottom side of the second substrate 57. A third thin dielectric Mylar film substrate 60 separates the first substrate 55 and the second substrate 57. Each of these three substrates is approximately 0.001 inch thick.

Figures 15A, 15B, 15C and 15D show the respective layers of the arrays containing the lines 54, 56, 58 and 59 shown in Figure 14. The registration marks in these figures indicate the aligment of the respective layers. The top layer, shown in Figure 15A, contains the array of row antenna lines A1—32. The next layer, shown in Figure 15B, contains the array of column antenna lines A33—64. The following layer, shown in Figure 15C, contains the array of row drive lines DL1—4 and portions of the array of sense lines SL1—8. The bottom layer, shown in Figure 15D, contains the array of column drive lines DL5—8 and portions of the array of sense lines SL1—8. When these four layers are aligned as indicated by their registration marks, each of the row antenna lines A1—32 is capacitively coupled primarily to one of the row drive lines DL1—4 and to one of the sense lines SL1—8; and each of the column antenna lines A33—64 is capacitively coupled primarily to one of the column drive lines DL5—8 and to one of the sense lines SL18.

Referring again to Figure 14, the second substrate 57 is supported by a nonconductive mechanical support layer 61, which is covered on its bottom side by a grounded thin conductive, electrically shielding layer 62. The touch element array further includes a protective 0.005 inch Lexan plastic film layer 63 covering the top unsupported side of the first substrate 55. Optionally the touch element array may also include a paper overlay layer 64 having various indicia and/or patterns thereon to particularly indicate specific portions of the array.

Referring again to Figure 10, the microprocessor program for this alternative embodiment necessarily is modified in steps 4.3 and 4.6 to accommodate the fact that more than one touch element connected to the row antenna lines A1—32 and more than one touch element connected to the column antenna lines A33—64 may be touched during a valid touch. The program can be modified to exempt from the tolerance test the sense signal variation values (SSVV) derived from the two antenna lines on either side of the respective antenna lines from which ROWMAX and COLMAX are derived.

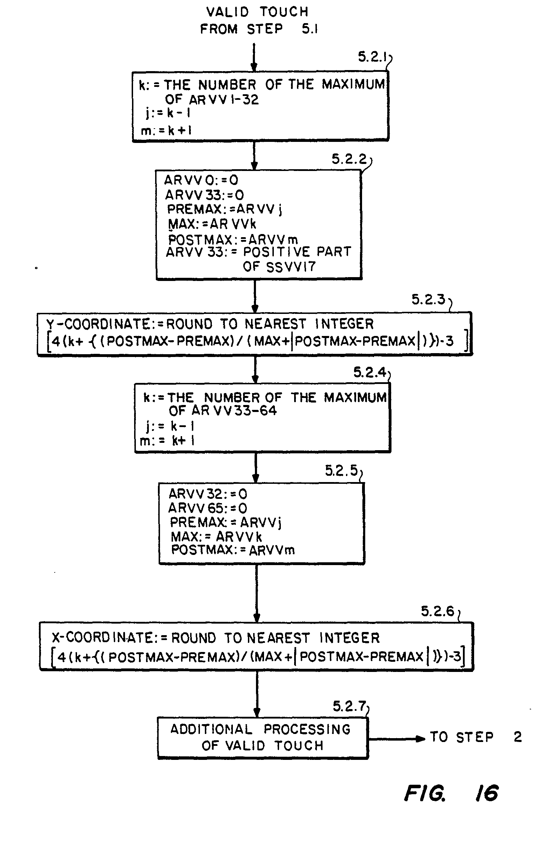

The principle modification of the microprocessor program is described with reference to Figure 16, which illustrates a flow chart for an interpolation process for calculating an x-coordinate and a y-coordinate for finger touch position. In this process it is convenient to redesignate each of the sense signal variation values SSVV1—32 as two parts, a positive part and a negative part. In this way 64 variables called antenna referred variation values and denoted ARVV1—64 are obtained from the 32 sense signal variation values SSVV1—32. The two of ARVV1—4 associated with each of SSVV1—32 are obtained by consulting TABLE 3 with the obvious interpretation in the present context. For example, the positive and negative parts of SSVV21 are assigned to ARVV49 and ARVV51 respectively upon consulting TABLE 3.

Referring to Figure 16, the interpolation routine for estimating the y coordinate of operator finger touch position from ARVV1—32 is set forth in steps 5.2.1 through 5.2.3, and the interpolation process for estimating the x coordinate of operator touch position from ARVV33—64 is set forth in steps 5.2.4 through 5.2.6. These steps are to be considered as an expansion in this preferred embodiment of step 5.2 of the process covered by the flow chart of Figure 10 for the first described preferred embodiment. These interpolation processes produce x and y coordinates which indicate the position of operator finger touch. Each coordinate is a number between 1 and 125.

In step 5.2.1 the variable k is assigned the number of the maximum of ARVV1—32; the variable j is assigned the value of k−1; and the variable m is assigned the value of k+1. For convenience, in step 5.2.2 a variable called ARVV0 is assigned the value 0 and ARVV33 is temporarily assigned the value 0. Next, variables PREMAX, MAX, and POSTMAX are assigned the respective values ARVVj, ARVVk, and ARVVm. Following this, the value of ARVV33 is restored to the value of the positive part of SSVV17. Next, in step 5.2.3 the variable Y-COORDINATE is calculated from the elementary interpolation formula:

$$Y = 4[k+\{(\text{POSTMAX-PREMAX})\div(\text{MAX}+|\text{POSTMAX-PREMAX}|)\}]-3 \qquad \text{(Eq. 1)}$$

Y is rounded down to the nearest integer. It is evident that the term POSTMAX-PREMAX appearing in the interpolation formula is never greater than MAX and thus that the term (POSTMAX-PREMAX)/(MAX+|POSTMAX-PREMAX|) which is added to k always lies between minus 1/2 and plus 1/2. The correspondence of the calculated y-coordinate and the actual finger touch position will be clear on inspection of step 5.2.3. Next in steps 5.2.4 through 5.2.6 the interpolation routine of steps 5.2.1 through 5.2.3 is repeated with obvious mondifications to calculate the variable X-COORDINATE. In step 5.2.7 additional processinng of VALID TOUCH by methods well known to those versed in the art are indicated.

A further modification of the microprocessor program for this alternative embodiment is to exempt from the tolerance test of steps 4.3 and 4.6 described in relation to the flow chart of Figure 10, the antenna referred variation values (ARVV) derived from the two adjacent antenna lines on each side of the antenna line associated with the maximum ARVV. In this alternative embodiment the ARVVs correspond to the SSVVs in Figure 10.

The remaining features of the embodiment of Figure 1 are likewise applicable to this alternative preferred embodiment.

There are several changes that can be made in the foregoing described preferred embodiments within the scope of the present invention. For example, in the embodiment of Figure 2, there are eight drive lines DL1—8 and eight sense lines SL1—8 leading to the matrix of T-bridge connections. It is apparent that by suitable analog switching, a line could serve as a drive line at one time and as a sense line at another time. In particular, a 2-of-N coding scheme for the antenna lines could be used in which there are N combined drive and sense lines and (N(N-1))/2 antenna lines with each antenna line forming a T-bridge connection between a unique pair of the combined drive and sense lines. This 2-of-N encoding scheme is well known to those versed in the art.

As shown in Figure 5, each touch element includes conductive tabs 20 and 21 extending respectively from a row antenna line A1—32 and a column antenna line A33—64. This encoding principle clearly could be extended so that the antenna lines could be divided into three or more groups and that finger contact with a touch element would result in an increase in the variable capacitance to ground of an antenna line from each of the three or more groups.

In Figure 4, a cross-sectional view of a touch element is shown. It is apparent that, in areas other than under tabs 20 and 21, the thin film substrate 22 need not remain close to the surface of the touch element

and could be covered by some of the supporting layer 23. In some applications this might be desired as a device to protect portions of the antenna lines not underlying the tabs 20, 21 from being affected by touch.

The drive signal patterns shown in Figure 6 illustrate a technique of achieving a balancing of drive signals by the simultaneous use of drive signals DS and inverted drive signals IDS on a pair of drive lines. It is apparent that other means of balancing could be found which avoid placing a drive signal on more than one drive line at a time and thus avoid having a simultaneous increase in the variable capacitance to ground (VCG) of two antenna lines go undetected such as the simultaneous increase in the VCG of antenna lines A1 and A3 as is apparent upon referring to Table 3.

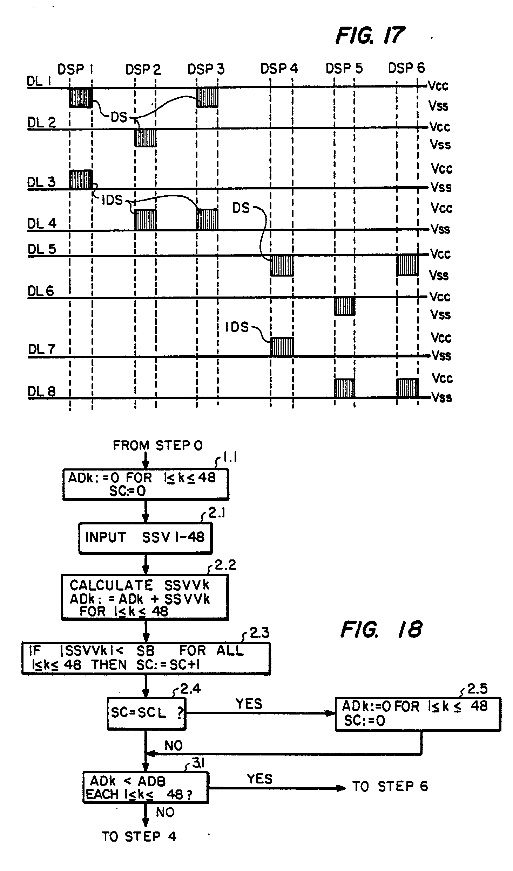

A technique for determining whether a sensed short term variation in the capacitance between an antenna line and circuit ground is due to the onset or the cessation of touching a touch element by an operator is described with reference to Figures 17—19. According to this technique the drive signals are provided on the drive lines DL1—8 by the drive signal generator 17 (Figure 1) in a repetitive sequence of six different drive signal patterns DSP1, DSP2, DSP3, DSP4, DSP5 and DSP6, as shown in Figure 17.

During DSP1, a drive signal DS is provided on drive line DL1 and an inverted drive signal IDS is provided on drive line DL3. TABLE 4 shows the association of the drive signals DS, the inverted drive signals IDS, and the drive lines DL during the six different drive signal patterns DSP.

TABLE 4

| | DSP1 | DSP2 | DSP3 | DSP4 | DSP5 | DSP6 |
|---|---|---|---|---|---|---|
| LINE RECEIVING DS | DL1 | DL2 | DL1 | DL5 | DL6 | DL5 |
| LINE RECEIVING IDS | DL3 | DL4 | DL4 | DL7 | DL8 | DL8 |

Location of DS and IDS on DL1-8 during DSP1-6

Referring again to Figure 17, it is seen that during each drive signal pattern, the paired drive signal DS and inverted drive signal IDS are synchronous with each other, of approximately the same value and of opposing polarities. During each cycle of drive signal patterns DSP1—6, a plurality of the drive signal packets, DS, IDS are applied sequentially on some of the drive lines and are paired synchronously with the drive signal packets of opposite polarity IDS, DS on different ones of the other drive lines. For example, drive signal packets DS are applied on drive line DL1 during sequential drive signal patterns DSP1 and DSP3 and are paired synchronously with inverted drive signals on drive lines DL3 and DL4 during drive signal patterns DSP1 and DSP3 respectively.

Over the course of the six different drive signal patterns during each repetitive sequence, a total of fortyeight different sense signal values SSV are derived from the eight sense lines SL1—8 and provided on lines 46 to the microprocessor 15. Table 5 shows the sign under the sign convention of Table 3 of the variation of the respective sense signal values SSV associated with the different antenna lines A that is due to the onset of an operator touching a touch element associated with the respective antenna lines. The SSV number is a processing sequence identification number and not the value of the sense signal.

TABLE 5

| ROW | | | | | | COLUMN | | | | | |
|---|---|---|---|---|---|---|---|---|---|---|---|
| A | SSV | SIGN | A | SSV | SIGN | A | SSV | SIGN | A | SSV | SIGN |
| 1 | 1,17 | + | 17 | 5,21 | + | 33 | 25,41 | + | 49 | 29,45 | + |
| 2 | 9 | + | 18 | 13 | + | 34 | 33 | + | 50 | 37 | + |
| 3 | 1 | - | 19 | 5 | - | 35 | 25 | - | 51 | 29 | - |
| 4 | 9,17 | - | 20 | 13,21 | - | 36 | 33,41 | - | 52 | 37,45 | - |
| 5 | 2,18 | + | 21 | 6,22 | + | 37 | 26,42 | + | 53 | 30,46 | + |
| 6 | 10 | + | 22 | 14 | + | 38 | 34 | + | 54 | 38 | + |
| 7 | 2 | - | 23 | 6 | - | 39 | 26 | - | 55 | 30 | - |
| 8 | 10,18 | - | 24 | 14,22 | - | 40 | 34,42 | - | 56 | 38,46 | - |
| 9 | 3,19 | + | 25 | 7,23 | + | 41 | 27,43 | + | 57 | 31,47 | + |
| 10 | 11 | + | 26 | 15 | + | 42 | 35 | + | 58 | 39 | + |
| 11 | 3 | - | 27 | 7 | - | 43 | 27 | - | 59 | 31 | - |
| 12 | 11,19 | - | 28 | 15,23 | - | 44 | 35,43 | - | 60 | 39,47 | - |
| 13 | 4,20 | + | 29 | 8,24 | + | 45 | 28,44 | + | 61 | 32,48 | + |
| 14 | 12 | + | 30 | 16 | + | 46 | 36 | + | 62 | 40 | + |
| 15 | 4 | - | 31 | 8 | - | 47 | 28 | - | 63 | 32 | - |
| 16 | 12,20 | - | 32 | 16,24 | - | 48 | 36,44 | - | 64 | 40,48 | - |

For example, at the onset of the touch element associated with row antenna line A1 and column antenna line A48 being touched by an operator there is a positive change in both sense signal values SSV1 and SSV17 and there is a negative change in both sense signal values SSV36 and SSV44.

It will be appreciated upon inspection of Table 5 that the change in sense signal values SSV1—48 brought about by the cessation of operator touch of a single touch element is distinct from the change brought about by the onset of operator touch. For example, the cessation of operator touch of a touch element associated with antenna line A5 produces opposite changes to those shown in Table 5. Thus there are significant negative changes produced in sense signal values SSV2 and SSV18. These negative changes are seen to uniquely indicate a cessation of operator touch of a touch element associated with antenna line A5. These changes are not those that occur with the onset of touch of a touch element associated with antenna line A8 because the required negative change in sense signal value SSV10 is not present. Also these changes are not those that occur with the onset of touch of a touch element associated with antenna line A7 since in that case a significant negative change in sense signal value SSV18 is not present.

The microprocessor 15 is programmed to process the sense signal values SSV1—48 on line 43 iteratively to ascertain the signs and values of the variations (SSVV) in the sense signal values (SSV) and to process the sense signal variation values (SSVV) to determine whether such variation resulted from a touch element being touched by an operator. The flow charts for this program are shown in Figures 7, 18 and 19.

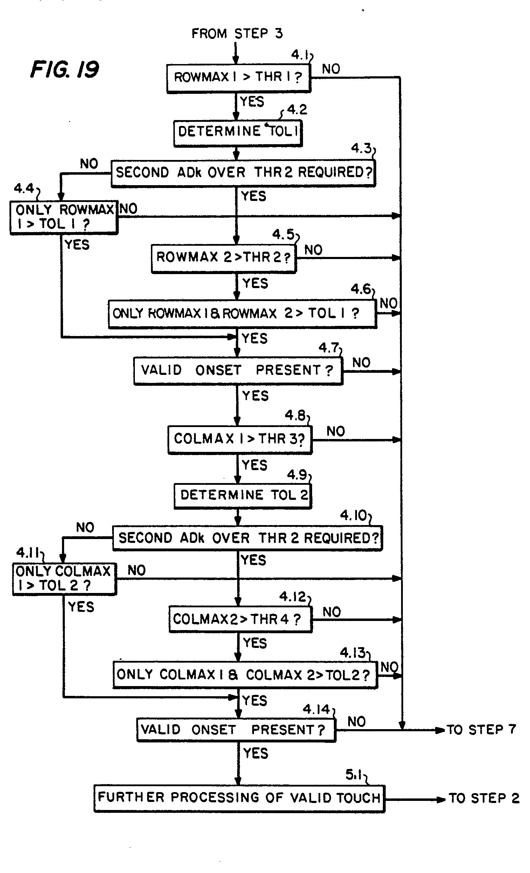

The steps described above in relation to Figure 7 for the first-described embodiment are also applicable to this program except that in step 2 a scan of the touch element array 10 is carried out iteratively with the production of sense signal values SSV1—48 as the program input. Significant program differences are shown in the flow charts of Figures 18 and 19. The step-numbering system in Figures 18 and 19 agrees in the first digit with that of Figure 7.

In the flow chart of Figure 18, step 1.1 consists of initializing accumulated difference values AD1—48 to zero annd a stability count SC to zero. Sense signal values SSV1—48 are input in step 2.1. Next, in step 2.2 the sense signal variation value SSVVk is calculated for each $1 \leq k \leq 48$ and is added to ADk. The previous sense signal value (SSVk) is then discarded and the current sense signal value of SSVk is saved. In step 2.3 a stability count SC is incremented if the magnitude of each SSVVk is found to be less than a predetermined stability bound SB for $1 \leq k \leq 48$. Next, in step 2.4 the stability count SC is compared to a predetermined count limit SCL. If there is equality there is a branch to step 2.5 where the accumulated difference values AD1—48 and the stability count SC are reset to zero. Otherwise there is a branch to step 3.1.

In step 3.1, if the magnitude of each accumulated difference value AD1—48 is found to be smaller than a predetermined accumulated difference bound ADB, the touch element array is judged to be in the UNTOUCHED state and there is a branch to step 6, otherwise there is a branch to step 4.

To summarize the function of the program shown in the flow chart of Figure 18, during each iteration (which corresponds to a sequence in which the drive signal pattern cycle DSP1—6 is repeated for each of the sense lines SL18), the current sense signal values SSV1—48 are compared with the respective sense signal values obtained during the previous iteration to determine sense signal variation values SSVV1—48. The sense signal variation values are added to the respective accumulated difference values AD1—48 for each sense signal; and each of the accumulated difference values AD1—48 is compared to a predetermined accumulated difference bound ADB to determine whether the UNTOUCHED state is present. The accumulated difference values AD1—48 are reset to an initial value of zero when each of the sense signal variation values SSVV1—48 remains less than a predetermined stability bound SB over a predetermined number of iterations SCL. Each of the sense signal variation values SSVV1—48 is compared to SB; and the stability count SC is incremented in response to each set of sense signal values SSV1—48 for which none of the sense signal variation values SSVV1—48 exceeds the predetermined stability bound SB. The accumulated difference values AD1—48 and the stability count SC are reset to an initial value of zero when the stability count SC reaches the predetermined count limit SCL.

Referring next to Figure 19, in the course of processing the accumulated differences AD1—48 the microprocessor 15 determines (a) ROWMAX1, the maximum magnitude of the accumulated differences AD1—24 which are the differences derived from the row antenna lines A1—32; (b) ROWMAX2, the second largest magnitude of AD1—24; (c) TOL1, a tolerance value which is a predetermined fraction of ROWMAX1; and (d) THR2, a predetermined fraction of ROWMAX1 which serves as a threshold value for ROWMAX2. The microprocessor 15 further determines (e) COLMAX1, the maximum magnitude of the accumulated differences AD25—48 which are the differences derived from the column antenna lines A33—64; (f) COLMAX2, the second largest magnitude of AD25—48; (g) TOL2, a tolerance value which is a predetermined fraction of COLMAX1; and (h) THR4, a predetermined fraction of COLMAX1 which serves as a threshold value for COLMAX2.

A valid touch onset is judged to be present when separate determinations relating to row antennas A1—32 and to column anhtennas A33—64 are affirmative.

Determinations related to row antennas A1—32 are that (i) ROWMAX1 must exceed a predetermined threshold value THR1; (j) if ROWMAX1 is derived from a row antenna line to which two drive signal packets are applied during each repetitive sequence of drive signal patterns DSP1—6, then ROWMAX2 must exceed the threshold THR2; (k) all magnitudes of the accumulated differences AD1—24 other than ROWMAX1, and when applicable ROWMAX2, must be less than TOL1; and (1) the specific one of AD1—24 giving rise to ROWMAX1, and when applicable the specific one of AD1—24 giving rise to ROWMAX2, must indicate, on consulting Table 5 (which is stored in the memory of the microprocessor 15), an appropriate response as concerns row antennas to the onset of touch of a single touch element.

Determinations related to column antennas A33—64 are that (m) COMAX1 must exceed a predetermined threshold value THR3; (n) if COLMAX1 is derived from a column antenna line to which two drive signal packets are applied during each repetitive sequence of drive signal patterns DSP1—6, then COLMAX2 must exceed the threshold THR4; (o) all magnitudes of the accumulated differences AD25—48 other than COLMAX1, and when applicable COLMAX2, must be less than TOL2; and (p) the specific one of AD25—48 giving rise to COLMAX1, and when applicable the specific one of AD25—48 giving rise to COLMAX2, must indicate, on consulting Table 5, an appropriate response as concerns column antennas to the onset of touch of a single touch element.

All of such of the eight immediately preceding recited determinations (i) (p) that are applicable being affirmative indicates the onset of only a single one of the touch elements being touched instantaneously by an operator.

Tests for a valid touch response are carried out in steps 4.1 through 4.14, as shown in the flow chart of Figure 19. In step 4.1 ROWMAX1 is compared to the first predetermined threshold value THR1. If ROWMAX1 exceeds THR1 there is a branch to step 4.2 where the tolerance value TOL1 is set to some fixed fraction of the value of ROWMAX1. Next, in step 4.3 if it is determined that ROWMAX1 is derived from a row antenna line to which two drive signal packets are applied during each repetitive sequence of drive signal patterns DSP1—6, whereby a valid touch response requires that the second largest magnitude of the accumulated difference values AD1—24, ROWMAX2, be over the threshold value THR2, there is a branch to step 4.5. Otherwise there is a branch to step 4.4 where each of the accumulated difference values AD1—24 other than the one chosen as ROWMAX1 is compared to the tolerance value TOL1.

If none of these values exceeds TOL1 then the program branches to step 4.7. In step 4.5 ROWMAX2 is compared to the threshold value THR2. If ROWMAX2 is found to be greater than THR2 there is a branch to step 4.6 where each of the accumulated difference values AD1—24 other than the ones chosen as ROWMAX1 and ROWMAX2 is compared to TOL1. If none of these values exceeds TOL1 there is a branch to step 4.7 where the accumulated difference associated with ROWMAX1 and when applicable the accumulated difference associated with ROWMAX2 are checked using the information in Table 5. If the result is found to be valid, then a VALID ROW TOUCH is judged to be present and the program branches to step 4.8.

In step 4.8, the variable COLMAX1 is compared to the threshold value THR3. If COLMAX1 exceeds THR3 then TOL2 is calculated as a fixed fraction of COLMAX1 in step 4.9. In step 4.10, if it is determined that COLMAX1 is derived from a column antenna line to which two drive signal packets are applied during each

repetitive sequence of drive signal patterns DSP1—6, whereby a valid touch response requires that the second largest of the accumulated difference values AD25—48, COLMAX2, be over the threshold value THR2, there is a branch to step 4.12. Otherwise there is a branch to step 4.ll where each of the accumulated difference values AD25—48 other than the one chosen as COLMAX1 is compared to the tolerance value TOL2. If none of these values exceeds TOL2, then the program branches to step 4.14. In step 4.12, COLMAX2 is compared to the threshold value THR4. If COLMAX2 is found to be greater than THR4, there is a branch to step 4.13 where each of the accumulated difference values AD25—48 other than the ones chosen as COLMAX1 and COLMAX2 is compared to TOL2. If none of these values exceeds TOL2, there is a branch to step 4.14 where the accumulated difference associated with COLMAX1 and when applicable the accumulated difference associated with COLMAX2 are checked using the information in Table 5. If the result is found to be valid, then the tests for a VALID TOUCH have been passed and there is an exit to step 5.l.

Failing any of the tests of steps 4.1, 4.4, 4.5, 4.6, 4.7, 4.8, 4.11, 4.12, 4.13, or 4.14 causes a branch to step 7 where an INVALID RESPONSE is processed. In step 5.1 processing of a VALID TOUCH response is carried out including the appropriate encoding of the touched touch element by row number and by column number which numbers may be calculated using the information in Table 5.

As an example of program parameter choices, suppose that accumulated difference (AD) values of over 16 units are reliably produced by operator touch under typical operating conditions. THR1 and THR3 may be set equal to 8. SCL may be chosen so that the accumulated differences AD are reset to 0 after 0.5 seconds of stable operation. In step 4.2 TOL1 may be assigned the value of ROWMAX1/4 and step 4.9 TOL2 may be assigned the value of COLMAX1/4. In step 4.5 THR2 may be assigned the value of ROWMAX1/2 and in step 4.12 THR4 may be assigned the value of COLMAX1/2.

It is thus a feature of this program that the accumulated difference values AD1—48 may be reset to zero when operator touch of a touch element is present for an extended dwell time without danger of misinterpretation of the subsequent accumulated difference values AD1—48 that occur when operator touch is removed from the touch element. This is in contrast to the situation described above in conjunction with the first-described preferred embodiment discussed in relation to Figures 6—12, where resetting baseline values (BV) during touch is prohibited since misinterpretation of the cessation of touch would then occur. This technique thus allows the indication of valid touch to be based exclusively on short term variations associated with the onset of valid touch.

Except for the differences discussed above in the description of the preferred embodinent of Figures 17—19, this preferred embodiment (Figures 17—19) is constructed and functions in the same manner as tlhe preferred embodiment first described above in relation to Figures 1—12.

## Claims

1. A capacitance-variation-sensitive touch sensing array arrangement comprising

an array of electrodes with each electrode including a conductive tab for increasing the capacitance between said electrode and ground upon a finger of an operator being brought into close proximity to said tab;

a plurality of drive lines (DL1—8), with each drive line being capacitively coupled to a plurality of the said electrodes by means of drive line-to-electrode capacitors (DLAC);

drive means (17) for applying drive signals having different predetermined characteristics to the different drive lines (DL1—8) to drive the electrodes coupled thereto;

a plurality of sense lines (SL1—8), with each of the sense lines being capacitively coupled to respective ones of a plurality of the said electrodes by means of electrode-to-sense line capacitors (ASLC) to derive sense signals from the electrodes when drive signals are applied to the drive lines with amplitudes of the derived sense signals being dependent upon whether the capacitance between driven electrodes and circuit ground is increased by operator touch;

means (11, 12) coupled to the sense lines for sensing the sense signals on the respective sense lines;

means (14) coupled to the sensing means (11, 12) to provide sense signal values in accordance with the amplitudes of the respective sense signals; and

means (15) for processing the sense signal values;

wherein the number of electrodes is greater than the sum of the number of drive lines (DL1—8) and the number of sense lines (SL1—8);

the arrangement being characterized by

each of said electrodes being designed as an antenna line (A1—64) including a plurality of conductive tabs connected together and by the antenna lines (A1—64) being arranged and disposed so as to form a coordinate grid underlying a touch responsive area with operator touch in any of a plurality of designated positions within said touch responsive area resulting in operator finger proximity to tabs from two or more of the said antenna lines and a corresponding increase in the capacitance to ground of said tabs from two or more of the said antenna lines; and

means (15, 16) for controlling the drive means (17) and means (11, 12, 13, 14, 15, 16) for sensing and processing the sense signals derived from the driven antenna lines (A1—64) to indicate a valid touch by an operator.

2. An arrangement according to Claim 1, wherein each antenna line is coupled to only one drive line and to only one sense line;

wherein each of the drive lines is coupled to a plurality of antenna lines;

wherein each of the sense lines is coupled to a plurality of antenna lines;

wherein no given drive line and sense line pair is connected to more than one antenna in common; and

wherein the drive means (17) are adapted for repetitively applying a sequence of drive signals having different predetermined characteristics to the different drive lines (DL1—8) to cause differently characterized sense signals to be derived on a sense line coupled to a plurality of different antenna lines.

3. An arrangement according to Claim 2, wherein the drive signals are alternating signal packets that differ from each other by being nonsynchronous or by being of opposing polarities if synchronous with each other.

4. An arrangement according to Claim 3 wherein the different drive signals in combination include nonsynchronous sets of pulsed signal packet pairs, with the paired signal packets in each set being synchronous with each other, of approximately the same value, and of opposing polarities to thereby cause the amplitude of the sense signals derived in response to said synchronous pairs of drive signal packets to be low in relation to the variation in the amplitude of said sense signals resulting from operator touch.

5. An arrangement according to Claim 1,

wherein the antenna lines (A1—64) are arrayed in rows (A1—32) and columns (A33—64);

wherein there is a unique touch element for each row antenna line and column antenna line pair;

wherein the touch elements (10) are arrayed as the keys of a keyboard; and

wherein each touch element includes one or more tabs (20) from the row antenna line and one or more tabs (21) from the column antenna line of said pair of row and column antenna lines and includes no tabs from other antenna lines.

6. An arrangement according to Claim 1,

wherein a first portion (A1—32) of the antenna array is supported by one side of a thin dielectric substrate (22) and a second portion (A33—64) of the antenna array is supported by the opposite side of the thin dielectric substrate (22); and

wherein any valid operator touch results in finger proximity to at least one tab supported by the one side of the substrate and extending from an antenna line of the first portion (A1—32) of the array and at least one tab supported by the opposite side of the substrate and extending from an antenna line of the second portion (A33—64) of the array so that the capacitance to ground is increased between at least one of the antenna lines of the first portion (A1—32) of the array and at least one of the antenna lines of the second portion (A33—64) of the array upon valid touch by an operator.

7. An arrangement according to Claim 1,

wherein the antenna lines (A1—64) are arrayed in rows (A1—32) and columns (A33—64);

wherein the antenna line array (A1—64) underlies a single large touch responsive area for use in the determination of the coordinates of touch position;

wherein there is a unique touch element (53) for each tab of each antenna line to vary the capacitance between said antenna line and ground upon the touch element being touched by an operator, and with the touch elements (53) being dimensioned and disposed so that an operator firmly touching an interior touch element (53) of the array (Fig. 13) with his finger necessarily touches one or more touch elements (53) associated with row antenna lines and one or more touch elements (53) associated with column antenna lines; and

wherein the means (15) coupled to the sensing means (11—14) processes the sense signals to provide an estimate of the location of operator touch.

8. An arrangement according to Claim 1 wherein the.

complete set of sense signal values is processed iteratively as a group by the processing means (15) to ascertain that a pattern of variations in the sense signal values characteristic of valid operator touch is present.

9. An arrangement according to Claim 5, wherein the drive signal generation means (17), drive signal control nmeans (15, 16) and sense signal processing means (15) are adapted so that the processing of the short term variations in the sense signals determines whether said variations resulted from only a single one of the touch elements being touched instantaneously by an operator.

10. An arrangement according to Claim 8, wherein the processing means (15) comprise

means (15) for processing the sense signal values iteratively by comparing the sense signal values with baseline values derived from sense signal values provided when the touch sensinhg array is untouched by an operator to determine which one of three states is present, the first of said three states being an untouched state, the second of said three states being a valid touch state in which a valid touch by an operator is judged to be present, and the third of said three states being an invalid response state which occurs when neither said first state or said second state is present; and

wherein the processing means (15) are adapted to revise the baseline values in response to sensed variations in the sensed signals which are stable over a predetermined number of iterations and which indicate the invalid response state of the touch sensing array.

**Patentansprüche**

1. Anordnung mit einem berührungsempfindlichen, auf Kapazitätsänderungen ansprechenden Feld, umfassend

ein Feld von Elektroden, in dem jede Elektrode einen leitenden Fleck aufweist, um die Kapazität zwischen der Elektrode und Masse zu erhöhen, wenn ein Finger einer Bedienungsperson in enge Nachbarschaft zu dem Fleck gebracht wird;

eine Vielzahl von Treiberleitungen (DL1—8), wobei jede Treiberleitung kapazitiv mittels Treiberleitungszu-Elektroden-Kondensatoren (DLAC) mit einer Vielzahl der Elektroden gekoppelt ist;

Treibereinrichtungen (17) zur Anlegung von Treibersignalen mit verschiedenen vorbestimmten Eigenschaften an die verschiedenen Treiberleitungen (DL1—8), um die damit gekoppelten Elektroden anzutreiben;

eine Vielzahl von Fühlerleitungen (SL1—8), wobei jede dieser Fühlerleitungen kapazitiv mit jeweiligen einer Vielzahl der Elektroden gekoppelt ist, und zwar mittels Elektroden-zu-Fühlerleitungs-Kondensatoren (ASLC), um Fühlsignale von den Elektroden zu gewinnen, wenn Treibersignale an die Treiberleitungen angelegt sind, wobei die Amplituden der gewonnenen Fühlsignale davon abhängen, ob die Kapazität zwischen angetriebenen Elektroden und Schaltungsmasse durch Berührung der Bedienungsperson erhöht ist;

mit den Fühlleitungen gekoppelte Einrichtungen (11, 12), um die Fühlsignale auf den jeweiligen Fühlleitungen abzufühlen;

mit den Fühleinrichtungen (11, 12) gekoppelte Einrichtungen (14), um Fühlsignalwerte entsprechend den Amplituden der jeweiligen Fühlsignale zu liefern; und

Einrichtungen (15) zur Verarbeitung der Fühlsignalwerte;

wobei die Anzahl der Elektroden größer ist als die Summe der Anzahl der Treiberleitungen (DL1—8) und die Anzahl der Fühlleitungen (SL1—8); und

wobei die Anordnung dadurch gekennzeichnet ist,

daß jede der Elektroden als eine Antennenleitung (A1—64) ausgebildet ist und eine Vielzahl von miteinander verbundenen leitenden Flecken umfaßt, daß die Antennenleitungen (A1—64) derart angeordnet und verteilt sind, daß sie ein Koordinatengitter bilden, das unter einem berührungsempfindlichen Feld liegt, wobei die Bedienungspersonberührung in irgendeiner einer Vielzahl von bezeichneten Positionen innerhalb des berührungsempfindlichen Feldes dazu führt, daß der Bedienungspersonfinger in die Nähe von Flecken von zwei oder mehr der Antennenleitungen gebracht wird und damit zu einer entsprechenden Zunahme der Kapazität bezüglich Masse der Flecken von zwei oder mehreren der Antennenleitungen führt, und daß Einrichtungen (15, 16) vorgesehen sind, um die Treibereinrichtungen (17) und die Einrichtungen (11, 12, 13, 14, 15, 16) zum Abfühlen und Verarbeiten der Fühlsignale zu steuern, welche von den angetriebenen Antennenleitungen (A1—64) erhalten wurdenn um eine gültige Berührung durch eine Bedienungsperson anzuzeigen.

2. Anordnung nach Anspruch 1, bei der jede Antennenleitung nur mit einer Treiberleitung und nur mit einer Fühlleitung gekoppelt ist;

wobei jede der Treiberleitungen mit einer Vielzahl von Antennenleitungen gekoppelt ist;

wobei jede der Fühlleitungen mit einer Vielzahl von Antennenleitungen gekoppelt ist;

wobei kein vorgegebenes Treiberleitungsund Fühlleitungspaar mit mehr als einer gemeinsamen Antenne verbunden ist; und

wobei die Treibereinrichtungen (17) dazu ausgebildet sind, eine Sequenz von Treibersignalen mit verschiedenen vorbestimmten Eigenschaften wiederholt an die verschiedenen Treiberleitungen (DL1—8) anzulegen, um zu bewirken, daß unterschiedlich charakterisierte Fühlsignale auf einer Fühlleitung erzielt werden, die mit einer Vielzahl von verschiedenen Antennenleitungen gekoppelt ist.

3. Anordnung nach Anspruch 2, bei der die Treibersignale alternierende Signalpakete sind, die sich voneinander dadurch unterschieden, daß sie nichtsynchron sind oder entgegengesetzte Polaritäten aufweisen, wenn sie miteinander synchron sind.

4. Anordnung nach Anspruch 3, bei der die verschiedenen Treibersignale in Kombination nichtsynchrone Gruppen von gepulsten Signalpaketpaaren umfassen, wobei die gepaarten Signalpakete in jeder Gruppe synchron miteinander sind, ungefähr den gleichen Wert besitzen und entgegengesetzte Polaritäten aufweisen, so daß bewirkt wird, daß die in Abhängigkeit von den synchronen Paaren vonh Treibersignalpaketen erzielte Amplitude der Fühlsignale niedrig ist, in Bezug auf die Veränderung der Amplitude der Fühlsignale, die sich durch Berührung der Bedienungsperson ergibt.

5. Anordnung nach Anspruch 1,

bei der die Antennenleitungen (A1—64) in Reihen (A1—32) und Spalten (A33—64) feldmäßig angeordnet sind;

wobei ein einziges Berührungselement für jedes Reihen-Antennenleitungs und Spaltenantennenleitungspaar vorgesehen ist;

wobei die Berührungselemente (10) als die Tasten eines Tastenfeldes angeordnet sind; und

wobei jedes Berührungselement eines oder mehrere Flecken (20) von der Reihenantennenleitung und eines oder mehrere Flecken (21) von der Spaltenantennenleitung des Paars von Reihen- und Spaltenantennenleitungen umfaßt und keine Flecken von anderen Antennenleitungen umfaßt.

6. Anordnung nach Anspruch 1,

wobei ein erster Abschnitt (A1—32) der Antennenanordnung von einer Seite eines dünnen dielektrischen Substrats (22) getragen ist und ein zweiter Abschnitt (A33—64) der Antennenanordnung von der gegenüberliegenden Seite des dünnen dielektrischen Substrats (22) getragen ist; und wobei jede gültige Bedienungspersonberührung dazu führt, daß ein Finger in der Nähe wenigstens eines auf der einen Seite des Substrats getragenen Flecks angeordnet wird und sich von einer Antennenleitung des ersten Abschnitts (A1—32) der Anordnung erstreckt, und in der Nähe wenigstens eines auf der entgegengesetzten Seite des Substrats getragenen Flecks und sich von einer Antennenleitung des zweiten Abschnitts (A33—64) der Anordnung wegerstreckt, so daß die Kapazität nach Masse zwischen wenigstens einer der Antennenleitungen des ersten Abschnitts (A1—32) der Anordnung und wenigstens einer der Antennenleitungen des zweiten Abschnitts (A33—64) der Anordnung bei einer gültigen Berührung durch eine Bedienungsperson erhöht wird.

7. Anordnung nach Anspruch 1,

wobei die Antennenleitungen (A1—64) in Reihen (A1—32) und Spalten (A33—64) angeordnet sind;

wobei die Antennenleitungsanordnung (A1—64) unter einem einzigen großen berührungsempfindlichen Bereich liegt, und zwar zur Verwendung bei der Bestimmung der Koordinaten der Berührungsposition;

wobei ein einziges Berührungselement (53) für jeden Fleck jeder Antennenleitung vorgesehen ist, um die Kapazität zwischen der Antennenleitung und Masse zu verändern, wenn das Berührungselement durch eine Bedienungsperson berührt wird, und wobei die Berührungselemente (53) derart dimensioniert und angeordnet sind, daß eine ein inneres Berührungselement (53) der Anordnung (Fig. 13) fest berührende Bedienungsperson mit ihrem Finger notwendigerweise eines oder mehrere Berührungselemente (53) berührt, die Reihenantennenleitungen zugeordnet sind und eines oder mehrere Berührungselemente (53), die Spaltenantennenleitungen zugeordnet sind; und

wobei die Einrichtungen (15), die mit den Fühleinrichtungen (11—14) gekoppelt sind, die Fühlsignale verarbeitet, um eine Schätzung der Lage der Bedienungspersonberührung zu liefern.

8. Anordnung nach Anspruch 1, wobei die vollständige Gruppe von Fühlsignalwerten iterativ als eine Gruppe durch die Verarbeitungseinrichtungen (15) verarbeitet wird, um sicherzustellen, daß ein Muster von Variationen in den Fühlsignalwerten, die für eine gültige Bedienungspersonberührung charakteristisch sind, vorliegt.

9. Anordnung nach Anspruch 5, wobei die Treibersignalerzeugungseinrichtungen (17), die Treibersignalsteuereinrichtungen (15, 16) und die Fühlsignalverarbeitungseinrichtungen (15) derart ausgebildet sind, daß die Verarbeitung der Kurzzeitvariationen der Fühlsignale bestimmt, ob die Variationen sich daraus ergeben, daß ein einziges der Berührungselemente gleichzeitig von einer Bedienungsperson berührt wird.

10. Anordnung nach Anspruch 8, wobei die Verarbeitungseinrichtungen (15) umfassen:

Einrichtungen (15) zur iterativen Verarbeitung der Fühlsignalwerte durch Vergleichen der Fühlsignalwerte mit Grundlinienwerten, die von Fühlsignalwerten gewonnen wurden, die sich dann ergeben, wenn das berührungsempfindliche Feld von einer Bedienungsperson nicht berührt wird, um zu bestimmen, welcher von drei Zuständen vorliegt, wobei der erste der drei Zustände ein unberührter Zustand ist, der zweite der drei Zustände ein gültiger Berührungszustand, in dem die Beurteilung ergibt, daß eine gültige Berührung durch eine Bedienungsperson vorliegt, und der dritte der drei Zustände ein ungültiger Ansprechzustand ist, der dann auftritt, wenn weder der erste Zustand noch der zweite Zustand vorliegen; und

wobei die Verarbeitungseinrichtungen derart ausgebildet sind, daß sie die Grundlinienwerte in Abhängigkeit von gefühlten Variationen in den Fühlsignalen revidieren, welche über eine vorbestimmte Anzahl von Iterationen stabil sind und die den ungültigen Ansprechzustand des berührungsempfindlichen Feldes anzeigen.

**Revendications**

1. Système à tableau sensible au toucher et aux variations de capacité, comprenant

une rangée d'électrodes, chaque électrode présentant un taquet conducteur pour augmenter la capacitè entre ladite électrode et la masse lorsqu'un doigt d'un opérateur est amené à proximité directe dudit taquet;

de multiples lignes d'excitation (DL1—8), chaque ligne d'excitation étant couplée capacitivement à plusieurs desdites électrodes au moyen de condensateurs (DLAC) ligne d'excitation -électrode;

un moyen d'excitation (17) pour appliquer, aux différentes lignes d'excitation (DL1—8), des signaux d'excitation présentant des caractéristiques prédéterminées différentes, afin d'exciter les électrodes qui y sont couplées;

de multiples lignes de détection (SL1—8), chacune des lignes de détection étant couplée capacitivement à quelquesunes respectives des multiples électrodes précitées, au moyen de condensateurs (ASLC) électrode — ligne de détection, afin de dériver des signaux de détection à partir des électrodes lorsque des signaux d'excitation sont appliqués aux lignes d'excitation, des amplitudes des signaux de détection dérivés étant dépendantes du fait que la capacité entre des électrodes excitées et la masse du circuit est augmentée par un effleurement de l'opérateur;

des moyens (11, 12) couplés aux lignes de détection, pour repérer les signaux de détection sur les lignes respectives de détection;

un moyen (14) couplé aux moyens de repérage (11, 12), pour fournir des valeurs de signaux de détection en concordance avec les amplitudes des signaux respectifs de détection; et

un moyen (15) pour traiter les valeurs de signaux de détection;

le nombre d'électrodes étant supérieur à la somme du nombre de lignes d'excitation (DL1—8) et du nombre de lignes de détection (SL1—8);.

le système étant caractérisé par le fait que chacune desdites électrodes est conçue sous la forme d'une ligne d'antenne (A1—64) comprenant de multiples taquets conducteurs connectés les uns aux autres, et par le fait que les lignes d'antennes (A1—64) sont agencées et disposées de façon à former une grille coordonnée sousjacente à une zone réagissant au toucher, l'effleurement, par un opérateur, dans l'un quelconque de plusieurs emplacements bien définis, à l'intérieur de ladite zone réagissant au toucher, se traduisant par une proximité du doigt de l'opérateur vis-à-vis de taquets provenant de deux ou plus parmi lesdites lignes d'antennes, et par une augmentation correspondante de la capacité à la masse desdits taquets provenant de deux ou plus parmi lesdites lignes d'antennes; et par

des moyens (15, 16) pour commander le moyen d'excitation (17), et des moyens (11, 12, 13, 14, 15, 16) pour repérer et traiter les signaux de détection dérivés des lignes d'antennes excitées (A1—64), en vue d'indiquer un effleurement valable par un opérateur.

2. Système selon la revendication 1,

dans lequel chaque ligne d'antenne est couplée à seulement une ligne d'excitation et à seulement une ligne de détection;

dans lequel chacune des lignes d'excitation est couplée à de multiples lignes d'antennes;

dans lequel chacune des lignes de détection est couplée à de multiples lignes d'antennes;

dans lequel aucune paire considérée, comprenant une ligne d'excitation et une ligne de détection, n'est connectée en commun à plus d'une antenne; et

dans lequel les moyens d'excitation (17) sont conçus pour appliquer répétitivement, aux différentes lignes d'excitation (DL1—8), une succession de signaux d'excitation présentant différentes caractéristiques prédéterminées, de telle sorte que des signaux de détection à caractéristiques différentes soient dérivés sur une ligne de détection couplée à de multiples lignes d'antennes diffèrentes.

3. Système selon la revendication 2, dans lequel les signaux d'excitation sont des groupes de signaux alternatifs qui diffèrent les uns des autres du fait qu'ils sont non synchrones, ou bien présentent des polarités opposées s'ils sont mutuellement synchrones.

4. Système selon la revendication 3, dans lequel les différents signaux d'excitation renferment, en combinaison, des jeux non synchrones de paires de groupes de signaux pulsatoires, les groupes de signaux appariés de chaque jeu étant mutuellement synchrones, d'approximativement la même valeur et de polarités opposées, de telle sorte que l'amplitude des signaux de détection, dérivés en réaction auxdites paires synchrones de groupes de signaux d'excitation, soit faible par rapport à la variation intervenant dans l'amplitude desdits signaux de détection suite à l'effleurement par un opérateur.

5. Système selon la revendication 1,

dans lequel les lignes d'antennes (A1—64) sont agencées en des traverses (A1—32) et en des colonnes (A33—64);

dans lequel un seul et unique élément à effleurement est associé à chaque paire comprenant une ligne d'antenne en traverse et une ligne d'antenne en colonne;

dans lequel les éléments à effleurement (10) sont agencés comme les touches d'un clavier; et

dans lequel chaque élément à effleurement comprend un ou plusieurs taquets (20) provenant de la ligne d'antenne en traverse et un ou plusieurs taquets (21) provenant de la ligne d'antenne en colonne de ladite paire comprenant des lignes d'antennes en traverse et en colonne, et ne présente pas de taquets provenant d'autres lignes d'antennes.

6. Système selon la revendication 1,

dans lequel une première partie (A1—32) de la rangée d'antennes est supportée par l'un des côtés d'un mince substrat diélectrique (22), et une seconde partie (A33—64) de la rangée d'antennes est supportée par le côté opposé du mince substrat diélectrique (22); et

dans lequel un quelconque effleurement valable par un opérateur se traduit par une proximité digitale visà-vis d'au moins un taquet supporté par l'un des côtés du substrat et s'étendant à partir d'une ligne d'antenne de la première partie (A1—32) de la rangée, et d'au moins un taquet supporté par le côté opposé du substrat et s'étendant à partir d'une ligne d'antenne de la seconde partie (A33—64) de la rangée, de sorte que la capacité à la masse est augmentée entre au moins l'une des lignes d'antennes de la première partie (A1—32) de la rangée, et au moins l'une des lignes d'antennes de la seconde partie (A33—64) de la rangée lors d'un effleurement valable par un opérateur.

7. Système selon la revendication 1,

dans lequel les lignes d'antennes (A1—64) sont agencées en des traverses (A1—32) et en des colonnes (A33—64);

dans lequel la rangée de lignes d'antennes (A1—64) est sous-jacente à une grande zone unique réagissant au toucher, en vue d'une utilisation dans la détermination des coordonnées d'un emplacement d'effleurement;

dans lequel un seul et unique élément à effleurement (53) est associé à chaque taquet de chaque ligne d'antenne pour faire varier la capacité entre ladite ligne d'antenne et la masse lorsque l'élément à effleurement est effleuré par un opérateur, les éléments à effleurement (53) étant dimensionnés et disposés de telle sorte qu'un opérateur, effleurant fermement du doigt un élément à effleurement intérieur (53) de la rangée (figure 13), effleure nécessairement un ou plusieurs éléments à effleurement (53) associés à des lignes d'antennes en traverse, et un ou plusieurs éléments à effleurement (53) associés à des lignes d'antennes en colonne; et

dans lequel le moyen (15) couplé aux moyens de repérage (11—14) traite les signaux de détection pour fournir une estimation de l'emplacement de l'effleurement par l'opérateur.

8. Système selon la revendication 1, dans lequel le jeu intégral de valeurs de signaux de détection est traité itérativement comme un groupe par le moyen de traitement (15), afin de s'assurer de la présence d'un modèle de variations intervenant dans les valeurs des signaux de détection, caractéristiques d'un effleurement valable par l'opérateur.

9. Système selon la revendication 5, dans lequel le moyen (17) générateur de signaux d'excitation, les moyens (15, 16) de commande des signaux d'excitation et le moyen (15) de traitement des signaux de détection sont conçus de telle sorte que le traitement des variations à court terme, intervenant dans les signaux de détection, détermine si lesdites variations ont résulté du fait que l'un seulement des éléments à effleurement est instantanément effleuré par un opérateur.

10. Système selon la revendication 8, dans lequel les moyens de traitement (15) comprennent

un moyen (15) pour traiter itérativement les valeurs de signaux de détection, en comparant ces valeurs des signaux de détection à des valeurs de lignes de base dérivées de valeurs de signaux de détection délivrées lorsque le tableau sensible au toucher n'est pas effleuré par un opérateur, de façon à déterminer laquelle parmi trois conditions est présente, la première desdites trois conditions étant une condition non effleurée, la deuxième desdites trois conditions étant une condition d'effleurement valable dans laquelle un effleurement valable par un opérateur est estimé se produire, et la troisième desdites trois conditions étant une condition de réaction non valable, s'établissant lorsque ni ladite première condition, ni ladite seconde condition n'est présente; et

dans lequel les moyens de traitement (15) sont conçus pour rectifier les valeurs des lignes de base en réaction à des variations repérées intervenant dans les signaux détectés, qui sont stables sur un nombre d'itérations prédéterminé, et qui indiquent la condition de réaction non valable dans le tableau sensible au toucher.

RESET 51
DATA PROCESSOR
48
KEYBOARD OUTPUT
47
DRIVE SIGNAL PATTERN
42
DRIVE SIGNAL GENERATOR
17
DRIVE SIGNAL TIMING
41
MICRO-PROCESSOR
15
50
CONTROL LOGIC
16
SENSE SIGNAL VALUE
46
A/D
14
SYNCHRONOUS DEMODULATOR
13
45
49
AMP
12
44
43
MUX
11
SENSE LINES SL 1-8
ANTENNA-TO-SENSE LINE CAPACITORS
ASLC 1-64
COLUMN ANTENNA LINES A33-64
ROW ANTENNA LINES A1-32
TOUCH ELEMENT ARRAY
10
COLUMN ANTENNA LINES A33-64
ROW ANTENNA LINES A1-32
DRIVE LINE-TO-ANTENNA CAPACITORS
DLAC 1-64
COLUMN ANTENNA LINES A33-64
COLUMN DRIVE LINES
DL5-8
ROW DRIVE LINES
DL 1-4

FIG. 1

DL 1
DL 2
DL 3
DL 4
DL 5
DL 6
DL 7
DL 8
DLAC 1
DLAC 2
DLAC 3
DLAC 4
DLAC 29
DLAC 30
DLAC 31
DLAC 32
DLAC 33
DLAC 34
DLAC 35
DLAC 36
DLAC 37
DLAC 38
DLAC 39
DLAC 40
DLAC 61
DLAC 62
DLAC 63
DLAC 64
SL 1
SL 2
SL 3
SL 4
SL 5
SL 6
SL 7
SL 8
ASLC 1
ASLC 2
ASLC 3
ASLC 4
ASLC 33
ASLC 34
ASLC 35
ASLC 36
ASLC 37
ASLC 38
ASLC 39
ASLC 40
ASLC 61
ASLC 62
ASLC 63
ASLC 64
ASLC 29
ASLC 30
ASLC 31
ASLC 32
A 1
A 2
A 3
A 4
A 29
A 30
A 31
A 32
TOUCH ELEMENTS ARRAY 10
TE
A 33
A 34
A 35
A 36
A 62
A 63
A 64

*FIG. 2*

18
VCG
F
=
DLAC
A
DL
ASLC
SCG
VCG
TE
SL
V

*FIG. 3*

26
DIMENSION OF TOUCH ELEMENT PRINTED ON PROTECTIVE FILM
27
OVERLAY (OPTIONAL)
25
PROTECTIVE FILM, BACK-PRINTED WITH INDICIA
20
22
ROW ANTENNA TAB
SUBSTRATE
COLUMN ANTENNA TAB
21
23
MECHANICAL SUPPORT
24
SHIELDING

*FIG. 4*

FIG. 5
TOUCH
— ELEMENT —
ARRAY 10
22
TE
20
21
SL 1
SL 2
SL 3
SL 4
SL 5
SL 6
SL 7
SL 8
DL 1
DL 2
DL 3
DL 4
DL 5
DL 6
DL 7
DL 8
ASLC 29
ASLC 30
ASLC 31
ASLC 32
ASLC 33
ASLC 34
ASLC 35
ASLC 36
ASLC 37
ASLC 38
ASLC 39
ASLC 40
ASLC 61
ASLC 62
ASLC 63
ASLC 64
DLAC 1
ASLC 1
DLAC 2
ASLC 2
DLAC 3
ASLC 3
DLAC 4
ASLC 4
DLAC 29
DLAC 30
DLAC 31
DLAC 32
DLAC 33
DLAC 40
A1
A2
A3
A4
A29
A30
A31
A32

DSP 1
DSP 2
DSP 3
DSP 4
DL 1
DL 2
DL 3
DL 4
DL5
DL6
DL7
DL8
DS
IDS
Vcc
Vss
POWER ON, RESET
INITIALIZE
SCAN & PROCESS SSV1-32
CHANGES SMALL ?
YES
PROCESS UNTOUCHED STATE
NO
VALID TOUCH ?
NO
PROCESS INVALID RESPONSE
YES
PROCESS VALID TOUCH
0
1
2
3
4
5
6
7

FIG. 6

FIG. 7

FROM STEP 0
1.1
INPUT SSV1-32, STORE AS BV1-32 AND ALSO AS RV1-32
1.2
BDCC:=0
BRC:=0
TO STEP 2

FIG. 8

FROM STEP 1
2.1
INPUT SSV1-32
2.2
RV DRIFT COMPENSATION DUE ?
YES
2.4
RVk:=RVk+SIGN (SSVk-RVk) FOR 1 ≤ k ≤ 32
NO
2.3
|SSVk-RVk| > RVB ANY 1 ≤ k ≤ 32 ?
YES
2.5
RVk:=SSVk FOR 1 ≤ k ≤ 32
BRC:=0
NO
2.6
SSVVk:=SSVk-BVk FOR 1 ≤ k ≤ 32
3.1
|SSVVk| < VVB EACH 1 ≤ k ≤ 32?
YES CHANGE SMALL
TO BLOCK 6
NO
CHANGE NOT SMALL
TO STEP 4

FIG. 9

FIG. 10
CHANGE NOT SMALL FROM STEP 3
4.1
ROWMAX > THR ?
NO
YES
4.2
DETERMINE TOL
4.3
ONLY ROWMAX > TOL ?
NO
YES
4.4
COL MAX > THR ?
NO
YES
4.5
DETERMINE TOL
4.6
ONLY COL MAX > TOL ?
NO
NOT VALID TOUCH TO STEP 7
YES
VALID TOUCH
5.1
BDCC:=0
BRC:=0
5.2
FURTHER PROCESSING OF VALID TOUCH
TO STEP 2
FIG. 11
UNTOUCHED STATE SMALL CHANGES FROM STEP 3
6.1
BDCC:= BDCC + 2
6.2
BDCC ≥ BDCCL ?
NO
YES
6.3
BDCC:=0
6.4
BVk:= BVk + SIGN (SSVVk)
FOR 1 ≤ k ≤ 32
TO STEP 2
FIG. 12
NOT VALID TOUCH FROM STEP 4
7.1
BRC:= BRC + 1
IF BDCC > 0 THEN BDCC:=BDCC - 1
7.2
BRC = BRCL ?
NO
YES
7.4
BVk:= RVk
FOR 1 ≤ k ≤ 32
7.3
FURTHER PROCESSING OF INVALID RESPONSE
TO STEP 2

A33 A34 A35 A36 A37 A38 A39 A40 A41 ...
TE
A1
A2
A3
A4
A5
53
D

*FIG. 13*

64
OVERLAY (OPTIONAL)
63
PROTECTIVE FILM, BACKPRINTED WITH INDICIA
54
ROW ANTENNA (A1-32)
THIN PLASTIC FILM SUBSTRATE
COLUMN ANTENNA (A33-64)
55
56
THIN PLASTIC FILM SUBSTRATE
60
58
ROW DRIVE LINE OR SENSE LINE
THIN PLASTIC FILM SUBSTRATE
COLUMN DRIVE LINE OR SENSE LINE
57
59
61
MECHANICAL SUPPORT
62
SHIELDING

*FIG. 14*

A1
A2
A31
A32
A33
A34
A63
A64
SL1
SL2
SL3
SL4
SL5
SL6
SL7
SL8
DL1
DL2
DL3
DL4
DL5
DL6
DL7
DL8

FIG. 15A

FIG. 15B

FIG. 15C

FIG. 15D

VALID TOUCH
FROM STEP 5.1
5.2.1
k:=THE NUMBER OF THE MAXIMUM OF ARVV1-32
j:=k-1
m:=k+1
5.2.2
ARVV0:=0
ARVV33:=0
PREMAX:=ARVVj
MAX:=ARVVk
POSTMAX:=ARVVm
ARVV33:= POSITIVE PART OF SSVV17
5.2.3
Y-COORDINATE:=ROUND TO NEAREST INTEGER
[4(k+{(POSTMAX-PREMAX)/(MAX+|POSTMAX-PREMAX|)})-3]
5.2.4
k:=THE NUMBER OF THE MAXIMUM OF ARVV33-64
j:=k-1
m:=k+1
5.2.5
ARVV32:=0
ARVV65:=0
PREMAX:=ARVVj
MAX:=ARVVk
POSTMAX:=ARVVm
5.2.6
X-COORDINATE:=ROUND TO NEAREST INTEGER
[4(k+{(POSTMAX-PREMAX)/(MAX+|POSTMAX-PREMAX|)})-3]
5.2.7
ADDITIONAL PROCESSING OF VALID TOUCH
TO STEP 2

FIG. 16

FIG. 17

DSP 1
DSP 2
DSP 3
DSP 4
DSP 5
DSP 6
DL 1
DL 2
DL 3
DL 4
DL 5
DL 6
DL 7
DL 8
DS
IDS
Vcc
Vss

FROM STEP 0
1.1
ADk: =0 FOR 1≤k≤48
SC:=0
2.1
INPUT SSV 1-48
2.2
CALCULATE SSVVk
ADk: =ADk + SSVVk
FOR 1≤k≤48
2.3
IF |SSVVk|< SB FOR ALL
1≤k≤48 THEN SC:=SC+1
2.4
SC=SCL ?
YES
2.5
ADk:=0 FOR 1≤k≤48
SC:=0
NO
3.1
ADk < ADB
EACH 1≤k≤48 ?
YES
TO STEP 6
NO
TO STEP 4

FIG. 18

FIG. 19
FROM STEP 3
4.1
ROWMAX 1 > THR 1 ?
NO
YES
4.2
DETERMINE TOL 1
4.3
SECOND ADk OVER THR 2 REQUIRED?
NO
YES
4.4
ONLY ROWMAX 1 > TOL 1 ?
NO
YES
4.5
ROWMAX 2 > THR 2 ?
NO
YES
4.6
ONLY ROWMAX 1 & ROWMAX 2 > TOL 1 ?
NO
YES
4.7
VALID ONSET PRESENT ?
NO
YES
4.8
COLMAX 1 > THR 3?
NO
YES
4.9
DETERMINE TOL 2
4.10
SECOND ADk OVER THR 2 REQUIRED?
NO
YES
4.11
ONLY COLMAX 1 > TOL 2 ?
NO
YES
4.12
COLMAX2 > THR 4 ?
NO
YES
4.13
ONLY COLMAX 1 & COLMAX 2 > TOL2 ?
NO
YES
4.14
VALID ONSET PRESENT ?
NO
TO STEP 7
YES
5.1
FURTHER PROCESSING OF VALID TOUCH
TO STEP 2